# EUROPEAN PATENT APPLICATION

(11) **EP 4 597 590 A1**
(43) Date of publication of application: **06.08.2025**
(21) Application number: 23871494.3
(22) Date of filing: 08.08.2023
(51) Int. Cl.: H01L 33/58, F21S 2/00, G03B 15/05, H01L 33/08, H01S 5/42

(54) **LIGHT SOURCE DEVICE**

(30) Priority: 28.09.2022 JP 2022154367; 26.07.2023 JP 2023121891
(71) Applicant: NICHIA CORPORATION, Anan-shi, Tokushima 774-8601 (JP)
(72) Inventor: YAMAMOTO, Saiki, Anan-shi, Tokushima 774-8601 (JP); OKAHISA, Tsuyoshi, Anan-shi, Tokushima 774-8601 (JP); MATSUOKA, Shinya, Anan-shi, Tokushima 774-8601 (JP)
(74) Representative: Betten & Resch
(86) International application number: PCT/JP2023/028903
(87) International publication number: WO 2024/070252

(57) **Abstract**

A light source device includes one or more first light source parts, one or more second light source parts, and a light-shielding member located between the first and second light source parts. The first light source part includes two or more first stacked bodies. The second light source part includes one or more second stacked bodies. Each of the two or more first stacked bodies and the one or more second stacked bodies includes an n-type semiconductor layer, an active layer, and a p-type semiconductor layer stacked along the first direction. The two or more first stacked bodies of the first light source part are stacked continuously along the first direction. A quantity of the two or more first stacked bodies included in the first light source part is greater than a quantity of the one or more second stacked bodies included in the second light source part.

## Description

### [Technical Field]

The disclosure relates to a light source device.

### [Background Art]

In recent years, cameras are being mounted in mobile terminals such as smartphones and the like, and flashes that include light source devices for providing supplemental light are being mounted in such cameras. For example, angles of view of cameras can be adjusted by digital zoom. It is therefore desirable for a light source device to irradiate appropriate supplemental light that corresponds to the angles of view selectable by the camera.

### [Prior Art Documents]

### [Patent Literature]

Patent Literature 1: Japanese Utility Model Registration No. 3148493

### [Summary of Invention]

### [Problem to be Solved by the Invention]

Embodiments according to the disclosure are directed to provide a light source device that can irradiate appropriate supplemental light.

### [Means for Solving the Problem]

A light source device according to an embodiment of the disclosure includes one or more first light source parts, one or more second light source parts, and a light-shielding member located between the first light source part and the second light source part. The first light source part includes two or more first stacked bodies; and each of the two or more first stacked bodies includes an n-type semiconductor layer, an active layer, and a p-type semiconductor layer stacked along a first direction. The second light source part includes one or more second stacked bodies; and each of the one or more second stacked bodies includes an n-type semiconductor layer, an active layer, and a p-type semiconductor layer stacked along the first direction. The two or more first stacked bodies of the first light source part are stacked continuously along the first direction. A quantity of the two or more first stacked bodies included in the first light source part is greater than a quantity of the one or more second stacked bodies included in the second light source part.

A light source device according to an embodiment of the disclosure includes one or more first light source parts, one or more second light source parts, and a light-shielding member located between the first light source part and the second light source part. The first light source part includes two or more first stacked bodies; and each of the two or more first stacked bodies includes a first-conductivity-type semiconductor layer, an active layer, and a second-conductivity-type semiconductor layer stacked in the first stacked body. The second light source part includes one or more second stacked bodies; and each of the one or more second stacked bodies includes a first-conductivity-type semiconductor layer, an active layer, and a second-conductivity-type semiconductor layer stacked in the second stacked body. The two or more first stacked bodies of the first light source part are stacked continuously along a stacking direction of the first stacked body. A quantity of the two or more first stacked bodies included in the first light source part is greater than a quantity of the one or more second stacked bodies included in the second light source part.

### [Effects of the Invention]

According to embodiments of the disclosure, a light source device that can irradiate an appropriate supplemental light can be achieved.

### [Brief Description of Drawings]

[FIG. 1]

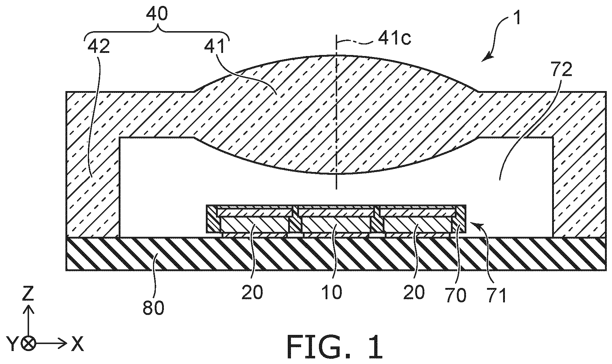

   FIG. 1 is a cross-sectional view showing a light source device according to a first embodiment.
[FIG. 2]

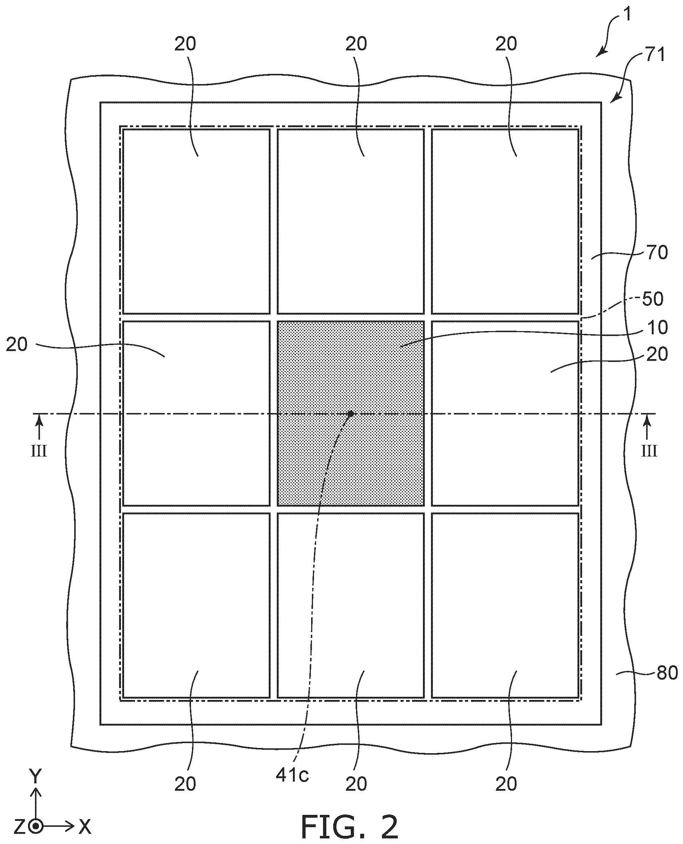

   FIG. 2 is a top view showing the light source device according to the first embodiment.
[FIG. 3]

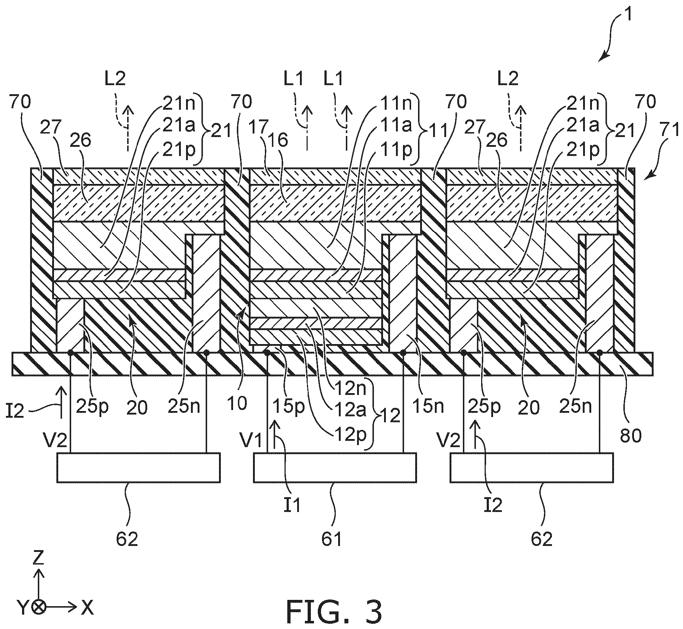

   FIG. 3 is a cross-sectional view along line III-III shown in FIG. 2.
[FIG. 4]

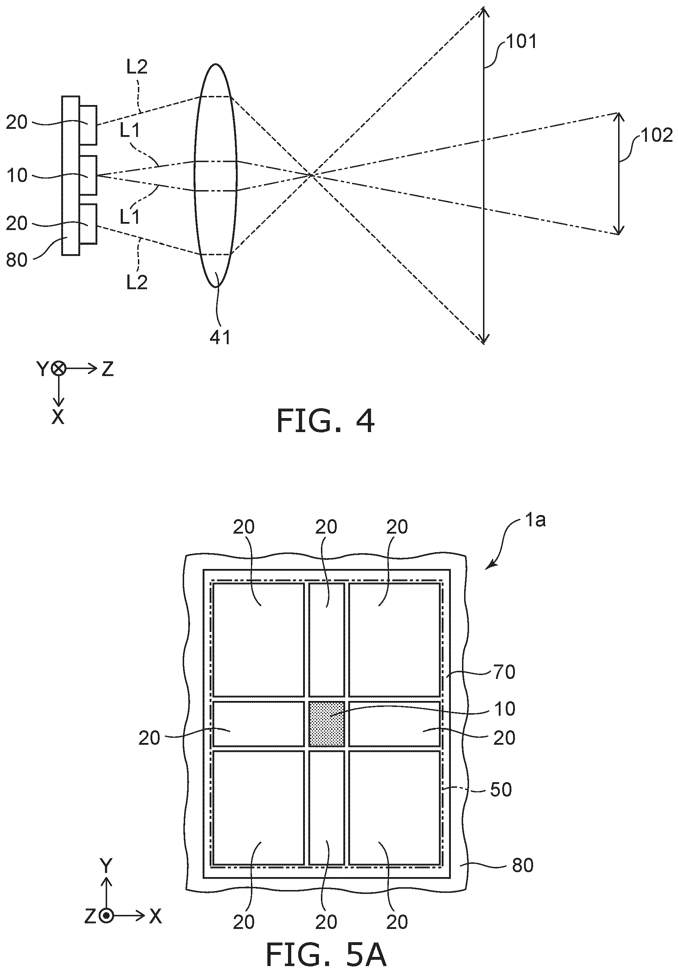

   FIG. 4 is a drawing showing an operation of the light source device according to the first embodiment.
[FIG. 5A]
   FIG. 5A is a top view showing a light source device according to a first modification of the first embodiment.
[FIG. 5B]

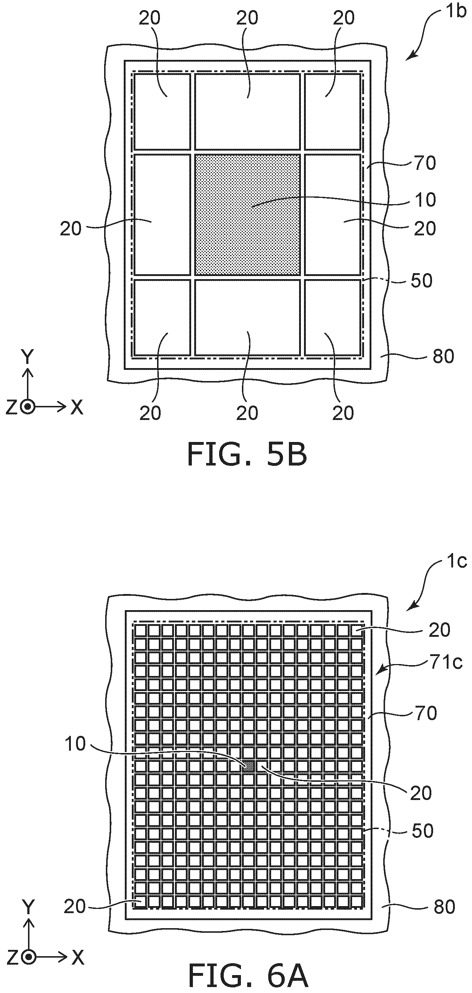

   FIG. 5B is a top view showing a light source device according to a second modification of the first embodiment.
[FIG. 6A]
   FIG. 6A is a top view showing a light source device according to a third modification of the first embodiment.
[FIG. 6B]

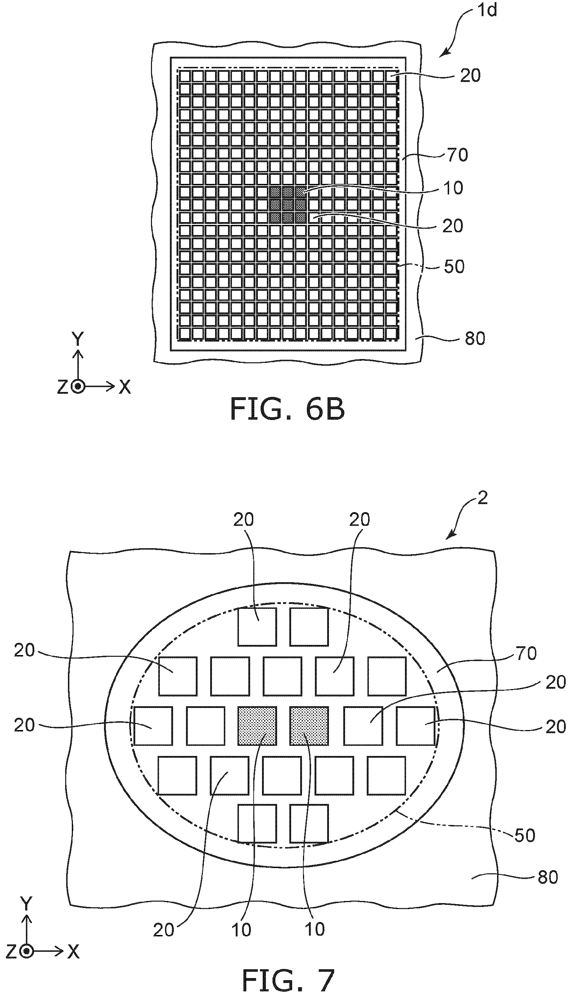

   FIG. 6B is a top view showing a light source device according to a fourth modification of the first embodiment.
[FIG. 7]
   FIG. 7 is a top view showing a light source device according to a second embodiment.
[FIG. 8]

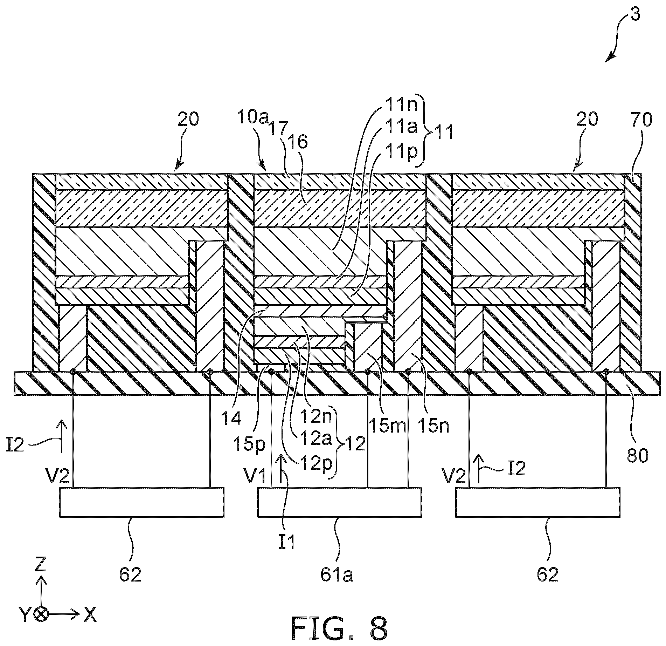

   FIG. 8 is a cross-sectional view showing a light source device according to a third embodiment.
[FIG. 9]

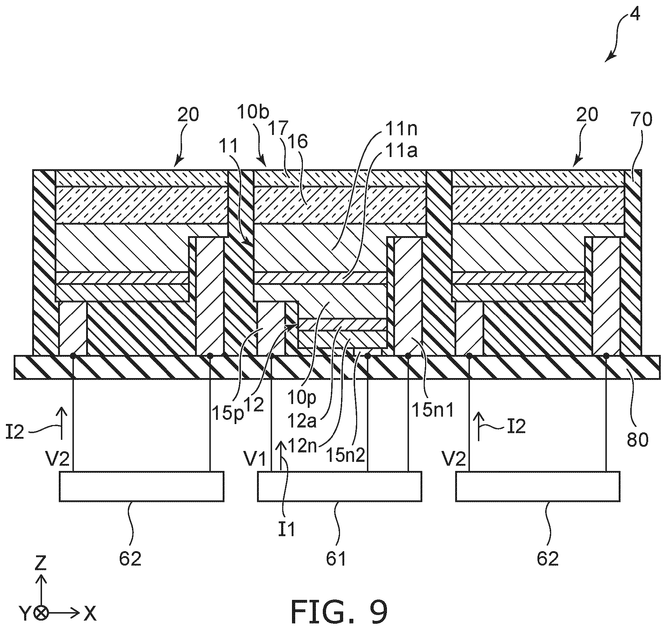

   FIG. 9 is a cross-sectional view showing a light source device according to a fourth embodiment.
[FIG. 10]

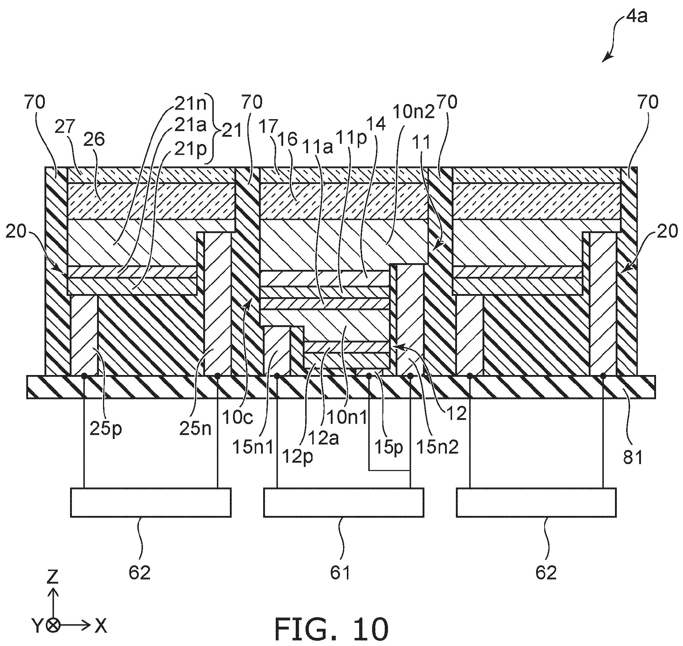

   FIG. 10 is a cross-sectional view showing a light source device according to a modification of the fourth embodiment.
[FIG. 11]

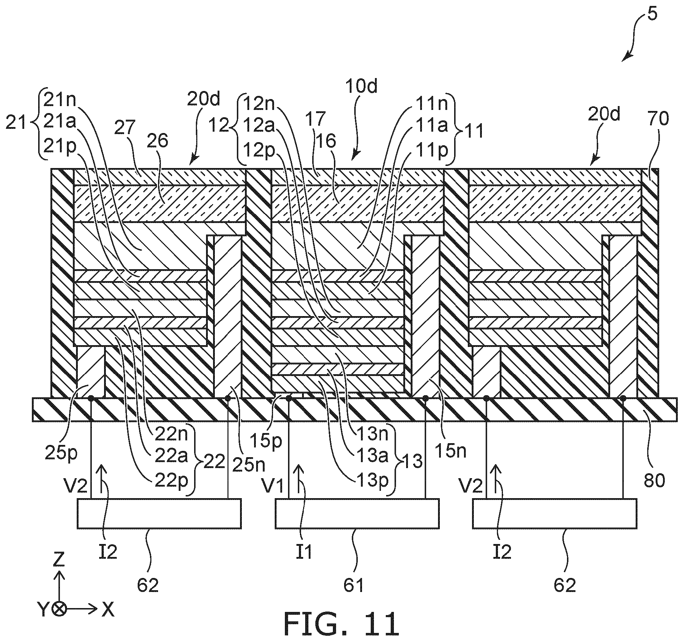

   FIG. 11 is a cross-sectional view showing a light source device according to a fifth embodiment.
[FIG. 12]

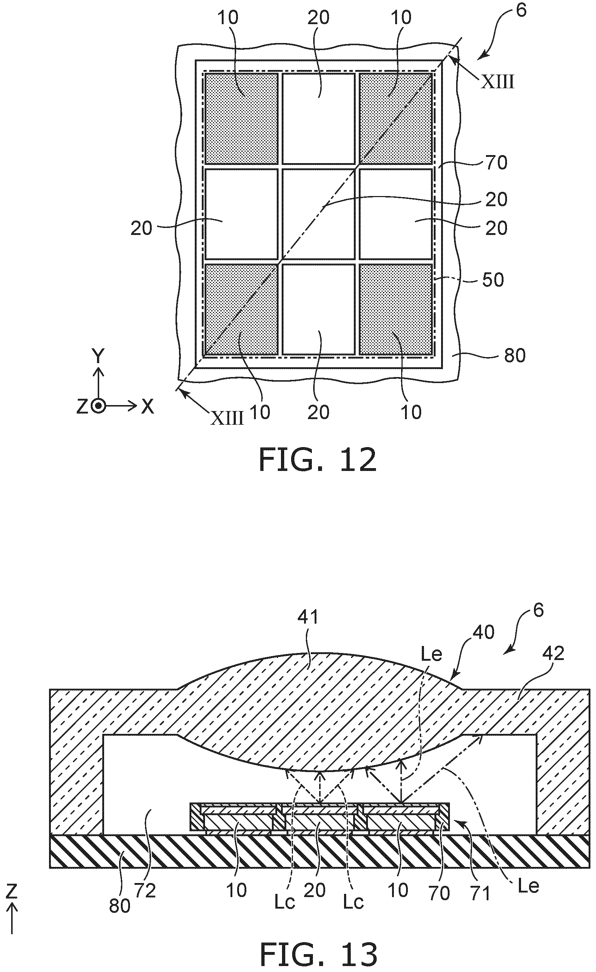

   FIG. 12 is a top view showing a light source device according to a sixth embodiment.
[FIG. 13]
   FIG. 13 is a drawing illustrating effects of the sixth embodiment, and is a cross-sectional view along line XIII-XIII shown in FIG. 12.
[FIG. 14A]

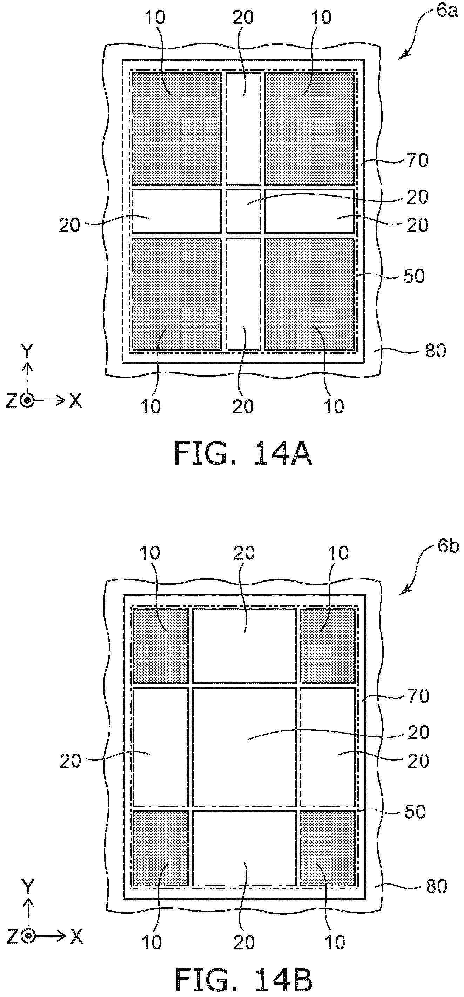

   FIG. 14A is a top view showing a light source device according to a first modification of the sixth embodiment.
[FIG. 14B]
   FIG. 14B is a top view showing a light source device according to a second modification of the sixth embodiment.
[FIG. 15A]

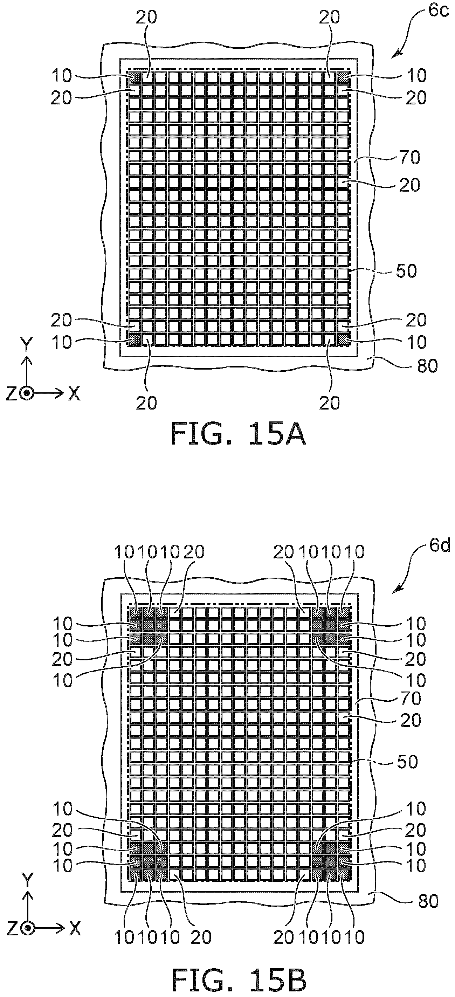

   FIG. 15A is a top view showing a light source device according to a third modification of the sixth embodiment.
[FIG. 15B]
   FIG. 15B is a top view showing a light source device according to a fourth modification of the sixth embodiment.
[FIG. 16]

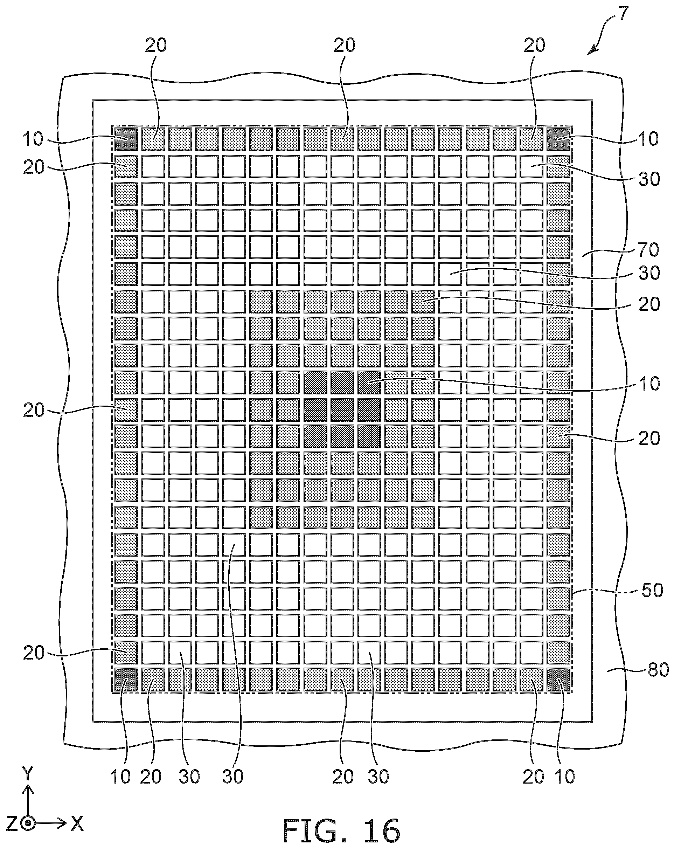

   FIG. 16 is a top view showing a light source device according to a seventh embodiment.
[FIG. 17]

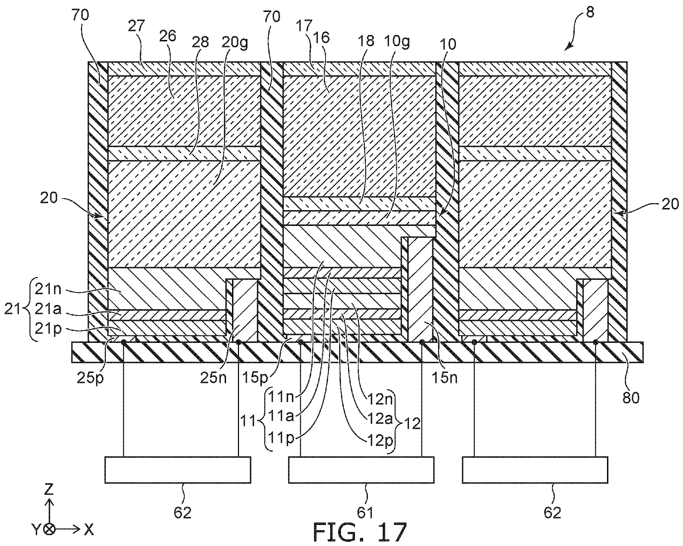

   FIG. 17 is a cross-sectional view showing a light source device according to an eighth embodiment.
[FIG. 18]

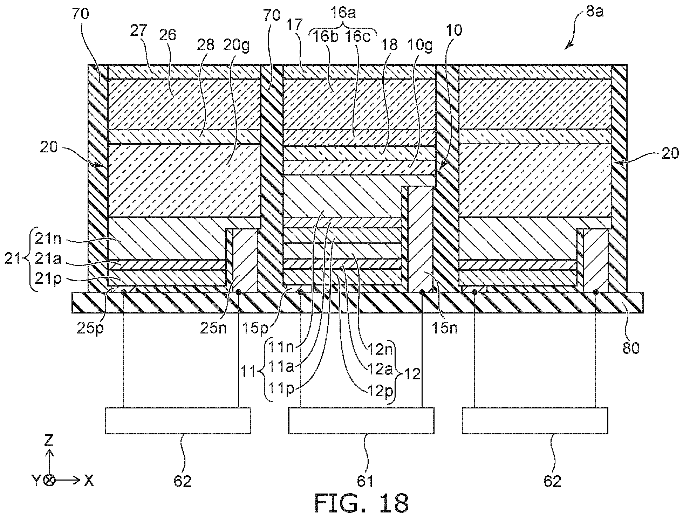

   FIG. 18 is a cross-sectional view showing a light source device according to a first modification of the eighth embodiment.
[FIG. 19]

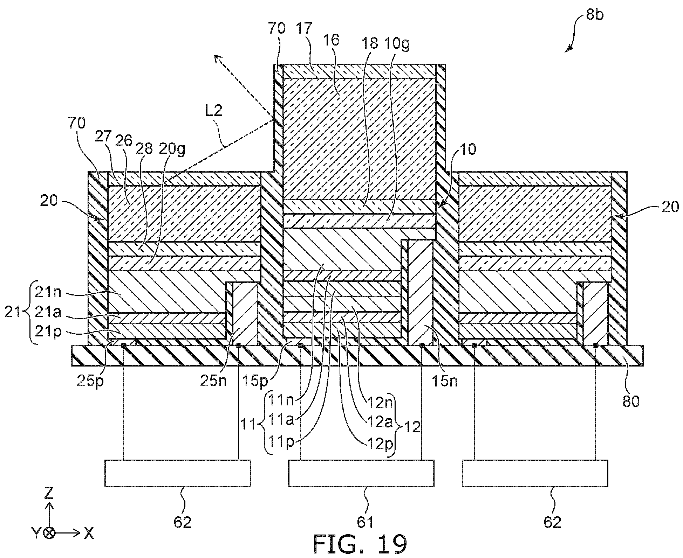

   FIG. 19 is a cross-sectional view showing a light source device according to a second modification of the eighth embodiment.
[FIG. 20A]

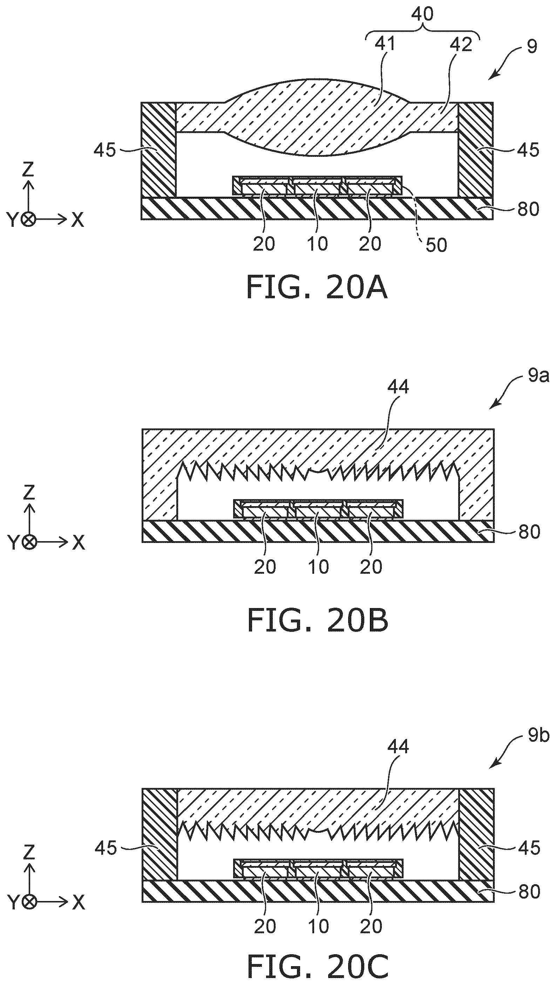

   FIG. 20A is a cross-sectional view showing a light source device according to a ninth embodiment.
[FIG. 20B]
   FIG. 20B is a cross-sectional view showing a light source device according to a first modification of the ninth embodiment.
[FIG. 20C]
   FIG. 20C is a cross-sectional view showing a light source device according to a second modification of the ninth embodiment.
[FIG. 20D]

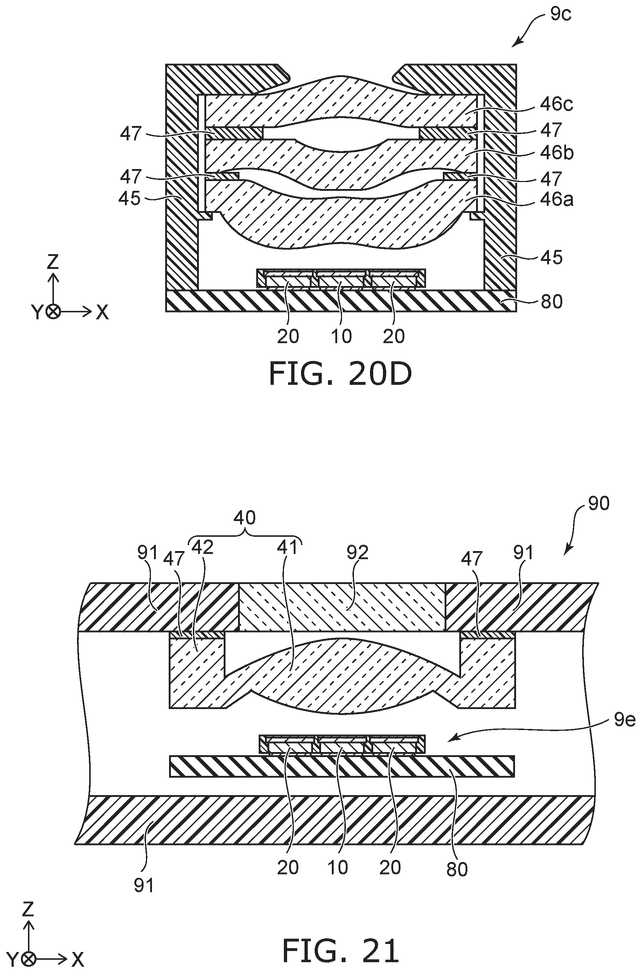

   FIG. 20D is a cross-sectional view showing a light source device according to a third modification of the ninth embodiment.
[FIG. 21]
   FIG. 21 is a cross-sectional view showing a light source device according to a tenth embodiment.
[FIG. 22A]

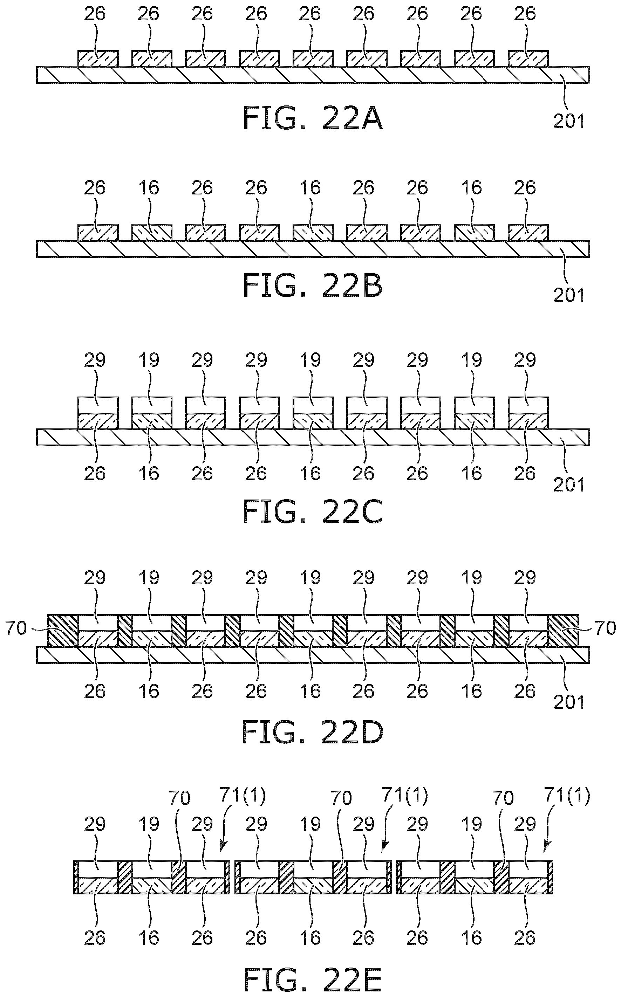

   FIG. 22A is a cross-sectional view showing a method for manufacturing a light source device according to an eleventh embodiment.
[FIG. 22B]
   FIG. 22B is a cross-sectional view showing the method for manufacturing the light source device according to the eleventh embodiment.
[FIG. 22C]
   FIG. 22C is a cross-sectional view showing the method for manufacturing the light source device according to the eleventh embodiment.
[FIG. 22D]
   FIG. 22D is a cross-sectional view showing the method for manufacturing the light source device according to the eleventh embodiment.
[FIG. 22E]
   FIG. 22E is a cross-sectional view showing the method for manufacturing the light source device according to the eleventh embodiment.

### [Detailed Description]

For example, a light source device according to the embodiment is used as a light source for a flash (an electroflash). Configurations and functions of light source devices will now be described in detail as examples of light source devices mounted with a camera in a mobile terminal such as a smartphone or the like and used as a flash light source for imaging. In the specification, "angle of view" refers to the range from which an image can be photographed on an image sensor, that is, the range that can be photographed on the image sensor, expressed as an angle.

### <First embodiment>

FIG. 1 is a cross-sectional view showing a light source device according to the embodiment.

FIG. 2 is a top view showing the light source device according to the embodiment.

FIG. 3 is a cross-sectional view along line III-III shown in FIG. 2.

The drawings are schematic, and are enhanced and simplified as appropriate. Also, the dimensional ratios of the components are not always consistent between the drawings. End views that show only cross sections may be used as cross-sectional views. This is similar for the other drawings described below as well. In the drawings, a portion of the light emitted from the first light source part may be illustrated by a double dot-dash-line arrow; and a portion of the light emitted from the second light source part may be illustrated by a broken-line arrow.

As shown in FIGS. 1 to 3, a light source device 1 according to the embodiment includes one or more first light source parts 10 and one or more second light source parts 20. The first light source part 10 includes two or more first stacked bodies; and each of the two or more first stacked bodies includes a first-conductivity-type semiconductor layer, an active layer, and a second-conductivity-type semiconductor layer stacked in the first stacked body. The two or more first stacked bodies are stacked continuously along the stacking direction of the first stacked body. The first light source part 10 according to the embodiment includes two or more first stacked bodies; and each of the two or more first stacked bodies includes a p-type semiconductor layer as a first-conductivity-type semiconductor layer, an active layer, and an n-type semiconductor layer as a second-conductivity-type semiconductor layer stacked along a first direction. The second light source part 20 includes one or more second stacked bodies; and each of the one or more second stacked bodies includes a first-conductivity-type semiconductor layer, an active layer, and a second-conductivity-type semiconductor layer stacked in the second stacked body. According to the embodiment, the second light source part 20 includes one or more second stacked bodies; and each of the one or more second stacked bodies includes a p-type semiconductor layer as a first-conductivity-type semiconductor layer, an active layer, and an n-type semiconductor layer as a second-conductivity-type semiconductor layer stacked along the first direction.

In the specification, an XYZ orthogonal coordinate system is employed for convenience of description. The direction in which the semiconductor layers are stacked is taken as a "first direction Z". Also, one of two directions in which the first light source parts 10 and the second light source parts 20 are arranged is taken as a "second direction X"; and the other of the two directions is taken as a "third direction Y". Among the first directions Z, the direction in which the semiconductor layers are stacked also is called "up", and the opposite direction also is called "down"; however, these expressions are for convenience and are independent of the direction of gravity. In the specification, "in a top view" refers to viewing an object from the major light-emitting surface side of the first and second light source parts (in other words, the first direction Z side).

In addition to these components, the light source device 1 may include a wiring substrate 80, a light-shielding member 70, a lens member 40, a first power supply circuit 61, and a second power supply circuit 62.

According to the embodiment as shown in FIG. 2, one first light source part 10 and eight second light source parts 20 are located on the wiring substrate 80. The first light source part 10 is marked with light hatching; and the second light source part 20 is not marked with hatching. One first light source part 10 and eight second light source parts 20 are arranged in a matrix configuration of three rows and three columns and form a light-emitting region 50 in a top view. In a top view, the first light source part 10 and the second light source part 20 are rectangles of substantially the same size (i.e., area); and the shape of the light-emitting region 50 is also rectangular. While being modifiable as appropriate according to the size of the light source device 1 in a top view and the quantity of light source parts, the areas of the first and second light source parts 10 and 20 in a top view are each, for example, not less than 0.001 mm² and not more than 1.5 mm². In the light-emitting region 50, all of the first light source parts 10 and second light source parts 20 are not necessarily lit constantly; and the first light source part 10 and the second light source parts 20 (hereinbelow, also generally referred to as simply the "light source parts") can be controlled individually or by group. In FIG. 2, the lens member 40, the first power supply circuit 61, and the second power supply circuit 62 are not illustrated for easier viewing of the drawing.

The first light source part 10 is located in the central region of the light-emitting region 50. The second light source parts 20 are located in the peripheral region of the light-emitting region 50. "The central region of the light-emitting region 50" includes the center of the light-emitting region 50, and is a region located away from the outer edge of the light-emitting region 50. "The peripheral region of the light-emitting region 50" is located at the periphery of the central region, and is a region including the outer edge of the light-emitting region 50. Therefore, two or more second light source parts 20 are located with the first light source part 10 interposed therebetween in a top view.

The first light source part 10 will now be described.

As shown in FIGS. 2 and 3, the first light source part 10 includes a first stacked body 11 and a first stacked body 12. In other words, the first light source part 10 includes two first stacked bodies. In the first light source part 10, the first stacked body 11 and the first stacked body 12 are stacked along the first direction Z (in other words, the stacking direction of the first stacked body). The first light source part 10 may also include an n-side electrode 15n, a p-side electrode 15p, and a first wavelength conversion member 16. Additionally, the first light source part 10 may further include a first light-transmitting member 17.

In the first stacked body 11, a p-type semiconductor layer 11p, an active layer 11a, and an n-type semiconductor layer 11n are stacked along the first direction Z. In the first stacked body 12, a p-type semiconductor layer 12p, an active layer 12a, and an n-type semiconductor layer 12n are stacked along the first direction Z. As a result, the first light source part 10 that includes the first stacked bodies 11 and 12 includes light-emitting diodes (Light-Emitting Diodes: LEDs). In the first light source part 10 as shown in FIG. 3, the p-type semiconductor layer 12p, the active layer 12a, the n-type semiconductor layer 12n, the p-type semiconductor layer 11p, the active layer 11a, and the n-type semiconductor layer 11n are stacked in this order along the first direction Z.

The first stacked body 11 and the first stacked body 12 are stacked continuously along the first direction Z. According to the embodiment, "stacked continuously" refers to the first stacked body 11 and the first stacked body 12 directly contacting each other via semiconductor layers. According to the embodiment, the p-type semiconductor layer 11p of the first stacked body 11 and the n-type semiconductor layer 12n of the first stacked body 12 contact each other. The first stacked body 11 and the first stacked body 12 may be bonded via semiconductor layers such as tunnel junction layers, etc. As a result, multiple first stacked bodies can be stacked, and the quantity of active layers of the light source part can be increased discretionary. Tunnel junction layers are described below.

The first stacked body 11 and the first stacked body 12 may not be stacked continuously, and may be bonded by interposing a conductive member such as an electrode or the like. In such a case, the electrode may be a transparent electrode formed of ITO (indium tin oxide), etc., or may be an electrode formed of metal. For such a configuration as well, multiple first stacked bodies can be stacked; accordingly, the quantity of active layers of the light source part can be increased discretionary.

The n-side electrode 15n is located at the position with which the n-type semiconductor layer 11n of the first stacked body 11 is in contact; and the n-type semiconductor layer 11n is connected with the wiring substrate 80 via the n-side electrode 15n. The p-side electrode 15p is located at the position with which the p-type semiconductor layer 12 of the first stacked body 12is in contact; and the p-type semiconductor layer 12p is connected with the wiring substrate 80 via the p-side electrode 15p. In the specification, "connected" means an electrical connection. The n-side electrode 15n and the p-side electrode 15p may be connected to the wiring substrate 80 via a bonding member. The bonding member is, for example, solder, a gold-tin alloy (AuSn), or an anisotropic conductive film (ACF).

The n-side electrode 15n and the p-side electrode 15p are connected to the first power supply circuit 61 included in the wiring substrate 80. The first power supply circuit 61 supplies a first voltage V1 to the first stacked bodies 11 and 12 that are connected in series.

The first wavelength conversion member 16 is located on the first stacked body 11. The first wavelength conversion member 16 is a member on which light that is emitted from at least one of the first stacked bodies (the first stacked body 11 or the first stacked body 12) included in the first light source part 10 is incident, and that emits wavelength-converted light. The first wavelength conversion member 16 includes at least a wavelength conversion substance. For example, the first wavelength conversion member 16 includes a light-transmitting material and a wavelength conversion substance; and the wavelength conversion substance may be dispersed in the light-transmitting material. The light-transmitting material may be, for example, an organic material such as a silicone resin, an epoxy resin, etc., or may be an inorganic material such as glass, etc. The wavelength conversion substance can include, for example, a wavelength conversion substance described below described below. Also, the first wavelength conversion member 16 may include titanium oxide (TiO₂), silica (SiO₂), alumina (Al₂O₃), etc., as a filler. A bonding member may be located between the first stacked body 11 and the first wavelength conversion member 16.

The first light-transmitting member 17 may be located on the first wavelength conversion member 16. The first light-transmitting member 17 is provided to disperse the light emitted from the first stacked body 11, the first stacked body 12, or both the first stacked body 11 and the first stacked body 12, to disperse the light emitted from the first wavelength conversion member 16, and to protect these members. The first light-transmitting member 17 includes a resin material. The first light-transmitting member 17 may also include, for example, a filler or the like that scatters the light inside the resin material. The resin material includes, for example, a silicone resin or an epoxy resin. The filler may include, for example, titanium oxide, silica, alumina, etc., and may include a combination of these substances.

The second light source part 20 will now be described.

The second light source part 20 includes a single second stacked body 21. In the second light source part 20 as shown in FIG. 3, a p-type semiconductor layer 21p, an active layer 21a, and an n-type semiconductor layer 21n stacked in this order toward the first direction Z. As a result, the second light source part 20 that includes the second stacked body 21 includes a light-emitting diode (LED).

Also, the second light source part 20 may include an n-side electrode 25n, a p-side electrode 25p, and a second wavelength conversion member 26. In addition to these components, the second light source part 20 may further include a second light-transmitting member 27. The second light-transmitting member 27 may be located on the second wavelength conversion member 26. The second light-transmitting member 27 is provided to disperse the light emitted from the second wavelength conversion member 26 and the light emitted from the second stacked body 21, a second stacked body 22, or both the second stacked body 21 and the second stacked body 22, and to protect these members. A bonding member may be located between the second stacked body 21 and the second wavelength conversion member 26. The materials of the second wavelength conversion member 26 and the second light-transmitting member 27 are, for example, respectively the same as the materials of the first wavelength conversion member 16 and the first light-transmitting member 17. However, the wavelength conversion substance contents may be different from each other.

The n-side electrode 25n is located at the position being in contact with the n-type semiconductor layer 21n of the second stacked body 21; and the n-type semiconductor layer 21n is connected with the wiring substrate 80 via the n-side electrode 25n. The p-side electrode 25p is located at the position being in contact with the p-type semiconductor layer 21p of the second stacked body 21; and the p-type semiconductor layer 21p is connected with the wiring substrate 80 via the p-side electrode 25p. The n-side electrode 25n and the p-side electrode 25p may be bonded to the wiring substrate 80 via the bonding member described above. The n-side electrode 25n and the p-side electrode 25p are connected to the second power supply circuit 62 via the wiring substrate 80. The second power supply circuit 62 supplies a second voltage V2 to the second light source part 20.

It is preferable to use a nitride semiconductor as the material of the first stacked body 11, the first stacked body 12, and the second stacked body 21. As a result, the wavelength conversion substance that is included in the first and second wavelength conversion members 16 and 26 can be efficiently excited. The nitride semiconductor is mainly represented by the general formula InₓAl*_{y}*Ga_{1-*x*-y}N (0 ≤ *x,* 0 ≤ *y,* and *x* + *y* ≤ 1). It is preferable for the light emission peak wavelength of the light emitted from each of the first stacked body 11, the first stacked body 12, and the second stacked body 21 (in other words, the first light source part 10 and the second light source part 20) to be in the range of not less than 400 nm and not more than 490 nm, and more preferably not less than 440 nm and not more than 475 nm from the perspective of the luminous efficiency, the wavelength conversion substance excitation, the color mixing relationship of the light emission, etc. Light in the range of not less than 500 nm and not more than 570 nm or not less than 600 nm and not more than 650 nm may be emitted. The peak wavelengths or colors of the light emitted from the first stacked body 11, the first stacked body 12, and the second stacked body 21 may be substantially the same, or the peak wavelength or color of at least one of such light may be different. The first light source part and the second light source part may respectively include laser diodes (LDs). Although the first-conductivity-type semiconductor layer is a p-type semiconductor layer and the second-conductivity-type semiconductor layer is an n-type semiconductor layer, according to the embodiment, the first-conductivity-type semiconductor layer may be an n-type semiconductor layer, and the second-conductivity-type semiconductor layer may be a p-type semiconductor layer.

The wavelength conversion substances included in the first and second wavelength conversion members 16 and 26 may include, for example, an yttrium-aluminum-garnet-based phosphor (e.g., (Y, Gd)₃(Al, Ga)₅O₁₂:Ce), a lutetium-aluminum-garnet-based phosphor (e.g., Lu₃(Al, Ga)₅O₁₂:Ce), a terbium-aluminum-garnet-based phosphor (e.g., Tb₃(Al, Ga)₅O₁₂:Ce), a CCA-based phosphor (e.g., Ca₁₀(PO₄)₆Cl₂:Eu), an SAE-based phosphor (e.g., Sr₄Al₁₄O₂₅:Eu), a chlorosilicate-based phosphor (e.g., Ca₈MgSi₄O₁₆Cl₂:Eu), a silicate-based phosphor (e.g., (Ba, Sr, Ca, Mg)₂SiO₄:Eu), an oxynitride-based phosphor such as a β-sialon-based phosphor (e.g., (Si, Al)₃(O, N)₄:Eu), an α-sialon-based phosphor (e.g., Ca(Si, Al)₁₂(O, N)₁₆:Eu), or the like, an LSN-based phosphor (e.g., (La, Y)₃Si₆N₁₁:Ce), a BSESN-based phosphor (e.g., (Ba, Sr) ₂Si₅N₈:Eu), an SLA-based phosphor (e.g., SrLiAl₃N₄:Eu), a nitride-based phosphor such as a CASN-based phosphor (e.g., CaAlSiN₃:Eu), a SCASN-based phosphor (e.g., (Sr, Ca)AlSiN₃:Eu), or the like, a fluoride-based phosphor such as a KSF-based phosphor (e.g., K₂SiF₆:Mn), a KSAF-based phosphor (e.g., K₂(Si_{1-*x*}Al*ₓ*)F_{6*-x*}:Mn, wherein x satisfies 0 < *x* < 1), a MGF-based phosphor (e.g., 3.5MgO·0.5MgF₂·GeO₂:Mn), or the like, a quantum dot having a perovskite structure (e.g., (Cs, FA, MA)(Pb, Sn)(F, Cl, Br, I)₃, wherein FA and MA respectively represent formamidinium and methylammonium), a Group II-VI quantum dot (e.g., CdSe), a Group III-V quantum dot (e.g., InP), a quantum dot having a chalcopyrite structure (e.g., (Ag, Cu)(In, Ga)(S, Se)₂), etc.

For example, the first stacked body 11 and the first stacked body 12 emit blue light. The wavelength conversion substance that is included in the first wavelength conversion member 16 absorbs a portion of the blue light emitted from the first stacked bodies 11 and 12 and radiates yellow light. As a result, the first light source part 10, as an entirety, emits white light by mixing blue light and yellow light. The first wavelength conversion member 16 may emit green light and red light by appropriately selecting the wavelength conversion substance. As a result, as an entirety, the first light source part 10 emits white light by mixing blue light, green light, and red light.

Similarly to the first light source part 10 described above, for example, the second stacked body 21 emits blue light. The wavelength conversion substance that is included in the second wavelength conversion member 26 absorbs a portion of the blue light emitted from the second stacked body 21 and radiates yellow light. As a result, as an entirety, the second light source part 20 emits white light by mixing blue light and yellow light. The second wavelength conversion member 26 may radiate green light and red light by appropriately selecting wavelength conversion substance. As a result, as an entirety, the second light source part 20 emits white light by mixing blue light, green light, and red light.

According to the embodiment, the first power supply circuit 61 is provided for each first light source part 10; and the second power supply circuit 62 is provided for each second light source part 20. Accordingly, according to the embodiment, one first power supply circuit 61 and eight second power supply circuits 62 are included. As a result, the light source device 1 can control the first light source part 10 and the second light source parts 20 independently from each other. It is sufficient to provide at least one second power supply circuit 62 for multiple second light source parts 20.

The differences between the first light source part 10 and the second light source part 20 will now be described.

According to the embodiment as described above, the first light source part 10 includes two first stacked bodies; and the second light source part 20 includes one second stacked body. Accordingly, the quantity of the first stacked bodies included in the first light source part 10 is greater than the quantity of the second stacked bodies included in the second light source part 20. It is sufficient for the quantity of the first stacked bodies included in the first light source part 10 to be two or more; and it is sufficient for the quantity of the second stacked bodies included in the second light source part 20 to be one or more. According to the embodiment, if the same amount of current is supplied to the first and second light source parts 10 and 20, the light emission amount of the first light source part 10 would theoretically be about 2 times the light emission amount of the second light source part 20.

To supply the same amount of current to the first and second light source parts 10 and 20, it is preferable for the first voltage V1 supplied by the first power supply circuit 61 to the first light source part 10 to be not less than 2 times the second voltage V2 supplied by the second power supply circuit 62 to the second light source part 20.

When the light emission amount of the first light source part 10 is greater than the light emission amount of the second light source part 20, it is preferable for the content of the wavelength conversion substance included in the first wavelength conversion member 16 to be greater than the content of the wavelength conversion substance included in the second wavelength conversion member 26. As a result, an appropriate wavelength conversion substance for the light emission amount of each light source part can be provided, and the degradation of the wavelength conversion substance due to light can be reduced. Also, the light emission color difference between the light source parts occurring due to the light emission amount difference between the light source parts can be adjusted.

Also, a wavelength conversion substance may be included in the bonding member located between the first stacked body 11 and the first wavelength conversion member 16; and a third wavelength conversion member that includes a wavelength conversion substance may also be provided on the first light-transmitting member 17. For such configurations as well, the necessary amount of the wavelength conversion substance for the first light source part 10 can be adjusted.

The light-shielding member 70 is located between the first light source part 10 and the second light source part 20 and in the outer perimeter portion of the light-emitting region 50. A light-emitting part 71 includes the first light source part 10, the second light source part 20, and the light-shielding member 70 that covers the first light source part 10 and the second light source part 20. The light-shielding member 70 may be a member that reflects the light emitted from the first and second light source parts 10 and 20 toward the first direction Z, or may be a member absorbing the light emitted from the first and second light source parts 10 and 20 traveling in a direction intersecting the first direction Z. For example, the light-shielding member 70 is formed of a white or black resin material. For example, a filler is dispersed in a resin material in the light-shielding member 70. To make the light-shielding member 70 white, for example, a substance such as titanium oxide, silica, alumina, or the like that scatters light is used as the filler. To make the light-shielding member 70 black, for example, a substance such as carbon, a coating, or the like that absorbs light is used as the filler. The resin material includes, for example, a silicone resin or an epoxy resin.

The lens member 40 is a member that transmits the light emitted from the first light source part 10 and the light emitted from the second light source part 20. It is sufficient for the lens member 40 to include at least a lens 41. According to the embodiment, the lens member 40 is formed of a light-transmitting material including the lens 41 and a support part 42 supporting the lens 41. The lens 41 and the support part 42 are formed as one piece. An air layer 72 is interposed between the light-emitting part 71 and the lens member 40. For example, the lens member 40 is formed of glass or a resin such as a polycarbonate resin, an acrylic resin, an epoxy resin, a silicone resin, etc.

The lens 41 is a biconvex lens. The lens 41 includes an incident surface at the first light source part 10 and second light source part 20 side, and includes an emission surface at the side (the first direction Z side) opposite to the incident surface. The lens 41 covers the light-emitting region 50 in a top view. A central axis 41c of the lens 41 extends in the first direction Z. The central axis 41c of the lens 41 overlaps the center of the light-emitting region 50 in a top view. For example, the light-emitting region 50 has 2-fold rotational symmetry with respect to the central axis 41c of the lens 41.

The support part 42 is frame-shaped or ring-shaped in a top view; and in FIG. 1, the lower end of the support part 42 is bonded to the wiring substrate 80. A bonding member may be interposed between the lens member 40 and the wiring substrate 80. The bonding member includes, for example, an epoxy resin or a silicone resin.

The wiring substrate 80 is a member to which the first light source part 10 and the second light source part 20 are mounted. As shown in FIG. 1, the lens member 40 may be located on the wiring substrate 80. Wiring parts are located inside and at the surface of an insulating base body of the wiring substrate 80, and are electrically connected with the first and second power supply circuits 61 and 62. The insulating base body includes, for example, a polyimide resin, a polyester resin, epoxy glass, a BT resin (bismaleimide triazine resin), aluminum nitride (AlN), silicon nitride (Si₃N₄), or alumina. For example, the wiring parts are formed of metal such as copper (Cu), gold (Au), etc. An ASIC (Application Specific Integrated Circuit) substrate may be used as the wiring substrate 80.

Operations of the light source device according to the embodiment will now be described.

FIG. 4 is a drawing showing an operation of the light source device according to the embodiment. In FIG. 4, the first light source part 10, the second light source part 20, the lens 41, and the wiring substrate 80 of the light source device 1 are illustrated for ease of description.

In the light source device 1 according to the embodiment as shown in FIGS. 2 and 3, two first stacked bodies (i.e., the first stacked body 11 and the first stacked body 12) are located in the first light source part 10 located in the central region of the light-emitting region 50; and one second stacked body 21 is located in each of the second light source parts 20 located in the peripheral region of the light-emitting region 50. Therefore, when the same current is caused to flow, the amount of light L1 emitted from one first light source part 10 is greater than that of light L2 emitted from one second light source part 20. Therefore, the light source device 1 has high luminous intensity toward the first direction Z.

As shown in FIG. 4, when the imaging angle of view of the camera used together with the light source device 1 is wide, that is, when the camera images a "wide angle", the light source device 1 irradiates light on an imaging subject 101 at a relatively short distance from the light source device 1. In such a case, for example, the light source device 1 causes all of the first and second light source parts 10 and 20 to emit light. The light L1 emitted from the first light source part 10 and the light L2 emitted from the second light source part 20 are condensed by the lens 41 of the lens member 40, then spread in a wide angle range, and are irradiated on the entire imaging subject 101. In such a case, the first power supply circuit 61 may set a first current I1 supplied to the first light source part 10 to be not less than 30% and not more than 70% of a second current I2 supplied to the second light source part 20 by the second power supply circuit 62, and may set the light emission amount of the first light source part 10 to be about the same as the light emission amount of each second light source part 20.

For example, when a camera images using a telephoto lens, the focal length of the telephoto lens is long, and a distant object can be enlarged. The angle of view decreases by the amount that the distant object can be enlarged, and the range that can be imaged becomes narrow; therefore, in the light source device 1, it is necessary for only the first light source part 10 positioned in the central region of the light-emitting region 50 to emit light. On the other hand, for example, when imaging using a wide-angle lens, the focal length of the wide-angle lens is shorter than that of the telephoto lens; and the angle of view can be increased. Therefore, in the light source device 1, it is necessary for both the first light source part 10 and the second light source parts 20 positioned in the central region and peripheral region of the light-emitting region 50 to emit light. When the imaging angle of view of the camera used together with the light source device 1 is narrow and the camera images "telephoto" mode, the light source device 1 irradiates light on an imaging subject 102 relatively distant to the light source device 1. In such a case, for example, only the first light source part 10 emits light, and the second light source parts 20 do not emit light. The light L1 that is emitted from the first light source part 10 is condensed by the lens 41 of the lens member 40, then spreads in a narrow angle range, and is irradiated on the imaging subject 102. Because two first stacked bodies (i.e., the first stacked body 11 and the first stacked body 12) are located in the first light source part 10, the amount of the light L1 emitted from the first light source part 10 can be large, and the imaging subject 102 that is at a longer distance from the light source device 1 than the imaging subject 101 can be brightly illuminated.

Effects of the embodiment will now be described.

Among the ranges irradiated by the light source device 1, for example, the quantity of light source parts contributing to the irradiation in "telephoto" having a narrow irradiation range is low. However, the distance between the light source device 1 and the imaging subject increases as the irradiation range becomes narrow (i.e., telephoto), and thus a high luminous intensity is desirable. According to the embodiment, even though the quantity of light source parts contributing to telephoto imaging (in other words, the first light source parts 10) is less than the quantity of light source parts contributing to wide-angle imaging (in other words, the total of the first and second light source parts 10 and 20), the light source device 1 can illuminate brightly because the quantity of the first stacked bodies included in the first light source part 10 is greater than the quantity of the second stacked bodies included in the second light source part 20. As described above, the light source device 1 can set the intensity distribution of the emitted light to be different between when the camera used together with the light source device 1 images "wide angle" and when the camera images "telephoto". As a result, a narrow angle range of "telephoto" can be illuminated brightly while being able to irradiate light in a wide angle range of "wide angle". Thus, even when the angle of view of the camera used together with the light source device 1 changes, the light source device 1 can brightly illuminate the imaging subject.

If the quantity of the second stacked bodies included in the second light source part is equal to the quantity of the first stacked bodies that can provide the appropriate light amount when imaging in "telephoto", the power provided to obtain a sufficient light amount when imaging in "wide angle" is greater than when the quantity of the second stacked bodies is less than the quantity of the first stacked bodies; and there is a risk that the luminous efficiency may be reduced. Accordingly, the light source device 1 of the embodiment in which the quantity of the first stacked bodies is greater than the quantity of the second stacked bodies can illuminate the imaging subject with high luminous efficiency in wide-angle imaging while having the light amount for telephoto imaging. Thus, according to the embodiment, because the light source part that has a several number of active layers is located at a specific location requiring much light amount, the imaging subject can be brightly illuminated.

Also, in the light source device 1, the content of the wavelength conversion substance included in the first wavelength conversion member 16 may be greater than the content of the wavelength conversion substance included in the second wavelength conversion member 26. As a result, even when the light emission amount of the first stacked bodies 11 and 12 are greater than the light emission amount of the second stacked body 21, the color of the light emitted from the first light source part 10 and the color of the light emitted from the second light source part 20 can be substantially the same. Also, the degradation of the wavelength conversion substance included in the first wavelength conversion member 16 can be suppressed from being faster than the wavelength conversion substance included in the second wavelength conversion member 26.

The amount of the wavelength conversion substance included in the first wavelength conversion member 16 may be set to be the same as the amount of the wavelength conversion substance included in the second wavelength conversion member 26; and the wavelength of the light emitted from the first stacked bodies 11 and 12 and the wavelength of the light emitted from the second stacked body 21 may be set to be different. In such a case as well, the chromaticity and/or color temperature of the light emitted from the first light source part 10 can substantially match the chromaticity and/or color temperature of the light emitted from the second light source part 20.

### <First modification of first embodiment>

A first modification of the first embodiment will now be described. The same names and reference numerals as those of the first embodiment above refer to the same or similar members; and a detailed description is omitted as appropriate. Also, the same components as those of the light source device 1 are not described and not-illustrated as appropriate; and the differences with the light source device 1 are mainly described. This is similar for the embodiments and modifications below as well.

FIG. 5A is a top view showing the light source device according to the modification.

In the light source device 1a according to the modification as shown in FIG. 5A, the size of the first light source part 10 is different from the size of the second light source part 20 in a top view. Specifically, the area of the first light source part 10 is less than the area of the second light source part 20 in a top view. Also, the four second light source parts 20 that are located at the corners of the light-emitting region 50 are larger than the four second light source parts 20 located with the first light source part 10 interposed along the firs direction X or the second_direction Y. For example, the ratio of the light of the light source parts located at the corners that is not incident on the lens 41 and becomes stray light is large; however, in the light-emitting device 1a of the modification, the amount of light incident on the lens 41 is increased by increasing the areas of the second light source parts 20 located at the corners; therefore, compared with the first embodiment, the light emission amount can be substantially uniform over the entire light-emitting region 50. Otherwise, the configuration, operations, and effects according to the modification are similar to those of the first embodiment.

### <Second modification of first embodiment>

FIG. 5B is a top view showing a light source device according to the modification.

In the light source device 1b according to the modification as shown in FIG. 5B, the area of the first light source part 10 is greater than the area of the second light source part 20 in a top view. As a result, much current can be supplied to the first light source part 10 because the electrical capacitance is increased by increasing the area of the semiconductor layer, and thus the illuminance of the front (in other words, the first direction Z) can be improved. Otherwise, the configuration, operations, and effects according to the modification are similar to those of the first embodiment.

### <Third modification of first embodiment>

FIG. 6A is a top view showing a light source device according to the modification.

In the light-emitting region 50 of the light source device 1c according to the modification as shown in FIG. 6A, seventeen of the first and second light source parts 10 and 20 are arranged along the X-direction, and twenty-one of the first light source parts 10 and the second light source parts 20 are arranged along the Y-direction to form a light-emitting part 71c. In other words, a total of 357 light source parts are arranged in a matrix configuration of twenty-one rows and seventeen columns. The area of the light source parts included in the light source device 1c is, for example, not less than 0.001 mm² and not more than 0.1 mm² in a top view.

Also, only one first light source part 10 is located in the central region of the light-emitting region 50; otherwise, the 356 light source parts are the second light source part 20. Thus, for example, by increasing the quantity of light source parts without changing the areas of the light-emitting parts in a top view, the intensity distribution of the light emitted from the light source device can be accurately controlled to match the angle of view of the camera and/or the position of the imaging subject. Otherwise, the configuration, operations, and effects according to the modification are similar to those of the first embodiment.

### <Fourth modification of first embodiment>

FIG. 6B is a top view showing a light source device according to the modification.

In the light-emitting region 50 in the light source device 1d according to the modification as shown in FIG. 6B as well, the light source parts are arranged in a matrix configuration of twenty-one rows and seventeen columns. Also, nine first light source parts 10 are arranged in a matrix configuration of three rows and three columns in the central region of the light-emitting region 50; and 348 second light source parts 20 are located around the first light source parts 10 and in the peripheral region of the light-emitting region 50.

According to the modification, nine first light source parts 10 are provided as one group. In such a case, only one first power supply circuit 61 may be provided for the nine first light source parts 10 included in the one group, or one first power supply circuit 61 may be provided for each first light source part 10. Similarly, multiple second light source parts 20 may be included in one group, 348 second light source parts 20 may be divided into multiple groups, and the second power supply circuits 62 may be provided respectively for each group of the second light source parts 20. As a result, the control is easy even when the quantity of light source parts is increased. According to the modification, if nine first light source parts 10 are provided as one group and one first power supply circuit 61 is provided for each first light source part 10, the quantity of the first light source parts 10 contributing to telephoto can be adjusted during telephoto imaging, and thus the tolerance of the telephoto magnification is increased. Otherwise, the configuration, operations, and effects according to the modification are similar to those of the first embodiment.

### <Second embodiment>

FIG. 7 is a top view showing a light source device according to the embodiment.

In the light source device 2 according to the embodiment as shown in FIG. 7, the arrangement of the light source parts is not a matrix configuration; and the light-emitting region 50 is elliptical in a top view. The first light source parts 10 are located in the central region of the light-emitting region 50; and the second light source parts 20 are located in the peripheral region of the light-emitting region 50. The arrangement of the light source parts is not limited thereto; for example, the light source parts may be arranged in a radial configuration or a concentric circular configuration. In the light source device 2 of the embodiment in which the light-emitting region 50 is elliptical in a top view, for example, compared to when the light-emitting region 50 is circular, the aspect ratio of the angle of view and the aspect ratio of the range illuminated by the light emitted from the lens 41 can be close to each other. Otherwise, the configuration, operations, and effects according to the embodiment are similar to those of the first embodiment.

### <Third embodiment>

FIG. 8 is a cross-sectional view showing a light source device according to the embodiment.

As shown in FIG. 8, the configuration of a first light source part 10a of the light source device 3 according to the embodiment is different from the configuration of the first light source part 10 according to the first embodiment.

In the first light source part 10a, the light emission color of the first stacked body 11 and the light emission color of the first stacked body 12 are different from each other. For example, the first stacked body 11 emits blue light; and the first stacked body 12 emits green light. The first light source part 10a may be made by continuously growing a semiconductor layer including the first stacked body 11 and a semiconductor layer including the first stacked body 12, or by bonding the first stacked body 11 and the first stacked body 12 that are separately prepared.

Also, in the first light source part 10a, a tunnel junction layer 14 is located between the first stacked body 11 and the first stacked body 12. The tunnel junction layer 14 contacts the p-type semiconductor layer 11p of the first stacked body 11 and the n-type semiconductor layer 12n of the first stacked body 12. The tunnel junction layer 14 includes at least one of a p-type semiconductor layer having a higher acceptor concentration than the p-type semiconductor layer 11p or an n-type semiconductor layer having a higher donor concentration than the n-type semiconductor layer 12n. In an example, the tunnel junction layer 14 includes a layer including a high concentration of magnesium (Mg) and a layer including a high concentration of silicon (Si). As a result, electrons and holes can be efficiently transferred.

In the first light source part 10a, a common electrode 15m is provided for the n-type semiconductor layer 12n of the first stacked body 12; and the common electrode 15m is connected to the wiring substrate 80. The common electrode 15m is connected to a first power supply circuit 61a via the wiring substrate 80.

In the light source device 3, when only the active layer 11a is caused to emit light, the common electrode 15m is set to be an anode; and the n-side electrode 15n is set to be a cathode. When only the active layer 12a is caused to emit light, the p-side electrode 15p is set to be an anode; and the common electrode 15m is set to be a cathode. When both the active layers 11a and 12a are caused to emit light, the p-side electrode 15p is set to be an anode; and the n-side electrode 15n is set to be a cathode.

When the p-side electrode 15p is set to be the anode and the n-side electrode 15n is set to be the cathode, a forward voltage is applied between the active layer 11a of the first stacked body 11 and the active layer 12a of the first stacked body 12; and both the active layers 11a and 12a emit light. At this time, a reverse voltage is applied to the tunnel junction (the p-n junction) of the tunnel junction layer 14. As a result, in the tunnel junction layer 14, electrons that are in the valence band tunnel into the conduction band; and a tunnel current flows.

When the first wavelength conversion member 16 includes a wavelength conversion substance that absorbs blue light and emits yellow light, and when only the active layer 11a is caused to emit light, the active layer 11a emits blue light, and a portion of the blue light that is incident on the first wavelength conversion member 16 is converted into yellow light and emitted. Therefore, the first light source part 10a emits mixed light of blue light and yellow light. When only the active layer 12a is caused to emit light, the active layer 12a emits green light, and a portion of the green light that is incident on the first wavelength conversion member 16 is converted into yellow light and emitted. Therefore, the first light source part 10a emits mixed light of green light and yellow light. When both the active layers 11a and 12a are caused to emit light, the first light source part 10a emits mixed light of blue light, green light, and yellow light.

Then, by controlling the current values supplied to the active layers 11a and 12a and the on/off duty ratio, the chromaticities of the light obtained by the light emission of the active layer 11a and the light emission of the active layer 12a can be adjusted. Thus, according to the embodiment, color adjustment of the first light source part 10a is possible. Otherwise, the configuration, operations, and effects according to the embodiment are similar to those of the first embodiment.

The light source device 3 may include three first stacked bodies; and the first stacked bodies may emit red, green, and blue light. The degree of freedom of the color adjustment can be increased by adjusting the light emission amounts of the first stacked bodies.

### <Fourth embodiment>

FIG. 9 is a cross-sectional view showing a light source device according to the embodiment.

As shown in FIG. 9, the configuration of a first light source part 10b of the light source device 4 according to the embodiment is different from the configuration of the first light source part 10 according to the first embodiment.

The stacking order of the semiconductors in the first stacked body 12 of the first light source part 10b is the reverse of that of the first embodiment. Also, the p-type semiconductor layer 12p of the first stacked body 12 and the p-type semiconductor layer 11p of the first stacked body 11 are formed to have a continuous body to form one p-type semiconductor layer 10p. Therefore, the n-type semiconductor layer 12n, the active layer 12a, the p-type semiconductor layer 10p, the active layer 11a, and the n-type semiconductor layer 11n are stacked in this order from the wiring substrate 80 toward the first wavelength conversion member 16 (in other words, along the first direction Z). The p-side electrode 15p is located at a position contacting the p-type semiconductor layer 10p. The first light source part 10b includes an n-side electrode 15n1 and an n-side electrode 15n2 as two n-side electrodes. The n-side electrode 15n1 is located at a position contacting the n-type semiconductor layer 11n; and the n-side electrode 15n2 is located at a position contacting the n-type semiconductor layer 12n. In FIG. 9, the p-type semiconductor layer 11p and the p-type semiconductor layer 12p are illustrated collectively as the p-type semiconductor layer 10p.

According to the embodiment, two first stacked bodies of the first light source part 10 are connected in parallel. In other words, the first stacked body 11 that is formed of the p-type semiconductor layer 10p, the active layer 11a, and the n-type semiconductor layer 11n and the first stacked body 12 that is formed of the p-type semiconductor layer 10p, the active layer 12a, and the n-type semiconductor layer 12n can be connected in parallel to the first power supply circuit 61. As a result, the first voltage V1 that drives the active layer 11a or the active layer 12a and the second voltage V2 that drives the active layer 21a can be set to be substantially the same; and it is easier to configure and control the power supply circuit. Also, when the first light source part 10b includes the active layer 11a and the active layer 12a that emit light of different wavelengths, the light of the active layers 11a and 12a can be mixed. Otherwise, the configuration, operations, and effects according to the embodiment are similar to those of the first embodiment.

The light source device according to the embodiment may include both a first light source part in which two or more first stacked bodies are connected in series, and a first light source part in which two or more first stacked bodies are connected in parallel.

### <Modification of fourth embodiment>

FIG. 10 is a cross-sectional view showing a light source device according to the modification.

As shown in FIG. 10, the configuration of a first light source part 10c of the light source device 4a according to the modification is different from the configuration of the first light source part 10b according to the fourth embodiment. Also, an ASIC substrate 81 is provided instead of the wiring substrate 80.

In the first light source part 10c, the stacking order of the semiconductors of the first stacked body 11 is different from that of the first embodiment. Also, the n-type semiconductor layer 12n of the first stacked body 12 and the n-type semiconductor layer 11n of the first stacked body 11 are formed to have a continuous body to form one n-type semiconductor layer 10n1. Furthermore, the tunnel junction layer 14 and an n-type semiconductor layer 10n2 are stacked on the first stacked body 11.

In other words, the p-type semiconductor layer 12p, the active layer 12a, the n-type semiconductor layer 10n1, the active layer 11a, the p-type semiconductor layer 11p, the tunnel junction layer 14, and the n-type semiconductor layer 10n2 are stacked in this order from the ASIC substrate 81 toward the first wavelength conversion member 16 (in other words, along the first direction Z).

The first light source part 10c includes a first electrode 15n1, a second electrode 15n2, and a third electrode 15p. The first electrode 15n1 is connected to the n-type semiconductor layer 10n1; and the second electrode 15n2 is connected to the n-type semiconductor layer 10n2. The third electrode 15p is connected to the p-type semiconductor layer 12p. Lighting control can be performed individually for the active layers 11a and 12a by the first power supply circuit 61 and the like to which the first electrode 15n1, the second electrode 15n2, and the third electrode 15p are connected. The second electrode 15n2 and the third electrode 15p are, for example, anode electrodes. The first electrode 15n1 is, for example, a cathode electrode.

According to the modification as well, similarly to the fourth embodiment, the first stacked body 11 and the first stacked body 12 are connected in parallel in the first light source part 10c. In other words, the first stacked body 11 that is formed of the p-type semiconductor layer 11p, the active layer 11a, and the n-type semiconductor layer 10n1 and the first stacked body 12 that is formed of the p-type semiconductor layer 11p, the active layer 12a, and the n-type semiconductor layer 10n1 can be connected in parallel to the first power supply circuit 61. Also, the current can be spread over the XY-plane by the n-type semiconductor layer 10n2 including the first electrode 15n1 that functions as a cathode electrode. Otherwise, the configuration, operations, and effects according to the modification are similar to those of the fourth embodiment.

### <Fifth embodiment>

FIG. 11 is a cross-sectional view showing a light source device according to the embodiment.

As shown in FIG. 11, the configurations of a first light source part 10d and a second light source part 20d of the light source device 5 according to the embodiment are respectively different from the configurations of the first and second light source parts 10 and 20 according to the first embodiment.

The first light source part 10d includes the first stacked body 11, the first stacked body 12, and a first stacked body 13 stacked continuously along the first direction Z. That is, the first light source part 10d includes three first stacked bodies. A p-type semiconductor layer 13p, an active layer 13a, and an n-type semiconductor layer 13n are stacked along the first direction Z in the first stacked body 13. The p-side electrode 15p is located at a position contacting the p-type semiconductor layer 13p. Therefore, the p-type semiconductor layer 13p, the active layer 13a, the n-type semiconductor layer 13n, the p-type semiconductor layer 12p, the active layer 12a, the n-type semiconductor layer 12n, the p-type semiconductor layer 11p, the active layer 11a, and the n-type semiconductor layer 11n are stacked in this order from the wiring substrate 80 toward the first wavelength conversion member 16 in the first light source part 10d.

The second light source part 20d includes the second stacked body 21 and a second stacked body 22 stacked continuously along the first direction Z similarly to the first stacked bodies 11, 12, and 13. That is, the second light source part 20d includes two second stacked bodies. A p-type semiconductor layer 22p, an active layer 22a, and an n-type semiconductor layer 22n are stacked along the first direction Z in the second stacked body 22. The p-side electrode 15p is connected to the p-type semiconductor layer 22p. Therefore, the p-type semiconductor layer 22p, the active layer 22a, the n-type semiconductor layer 22n, the p-type semiconductor layer 21p, the active layer 21a, and the n-type semiconductor layer 21n are stacked in this order from the wiring substrate 80 toward the second wavelength conversion member 26 (in other words, along the first direction Z) in the second light source part 20d.

In the light source device 5, when the magnitude of the current supplied to the first light source part 10d and the magnitude of the current supplied to the second light source part 20d are equal, and the materials, thicknesses, areas, etc., of the semiconductor layers included in the first and second light source parts 10d and 20d are the same as or similar to one another, the ratio of the light emission amount of the first light source part 10d to the light emission amount of the second light source part 20d is substantially (3:2). In such a case, the first voltage V1 that is supplied to the first light source part 10d by the first power supply circuit 61 is set to be not less than (3/2) times the second voltage V2 supplied to the second light source part 20d by the second power supply circuit 62.

To represent the relationships between the numbers of stacks and voltages of the light source parts more generally, when the magnitude of the current supplied to the first light source part 10d and the magnitude of the current supplied to the second light source part 20d are equal, and the materials, thicknesses, areas, etc., of the semiconductor layers included in the first and second light source parts 10d and 20d are the same as or similar to one another, the value (*V1*/*V2*) of the ratio of the first voltage V1 to the second voltage V2 is not less than the value (*N1*/*N2*) of the ratio of a quantity of stacks N1 of the first stacked bodies of the first light source part to a quantity of stacks N2 of the second stacked bodies of the second light source part. In other words, (*V1*/*V2*) ≥ (*N1*/*N2*). According to the embodiment, *N1* is 3 and *N2* is 2, and thus (*V1*/*V2*) ≥ (3/2). According to the first embodiment, N1 is 2 and *N2* is 1, and thus (*V1*/*V2*) ≥ (2/1) = 2. Otherwise, the configuration, operations, and effects according to the embodiment are similar to those of the first embodiment.

### <Sixth embodiment>

FIG. 12 is a top view showing a light source device according to the embodiment.

The arrangement of the first and second light source parts 10 and 20 of the light source device 6 according to the embodiment as shown in FIG. 12 is different from that of the first embodiment.

In the light source device 6, the light source parts are arranged in a matrix configuration of three rows and three columns and form the light-emitting region 50. One first light source part 10 is located at each of the four corners of the light-emitting region 50 in a top view. In other words, there are four first light source parts 10. The second light source parts 20 are located at the positions other than the four corners of the light-emitting region 50. In other words, there are five second light source parts 20.

An operation of the embodiment will now be described.

FIG. 13 is a cross-sectional view describing effects of the embodiment.

As shown in FIG. 13, the greater part of light Lc that is emitted from the light source part located in the central region of the light-emitting region 50 is incident on the lens 41 of the lens member 40. On the other hand, a portion of light Le emitted from the light source parts located at the corners of the light-emitting region 50 is incident on the support part 42 of the lens member 40. The light that is incident on the support part 42 becomes stray light; and the greater part of the stray light does not easily reach the imaging subject. Therefore, if the light emission amounts of all of the light source parts are substantially equal, there is a risk that the amount of light incident on the lens 41 from the light source parts located at the corners of the light-emitting region 50 decreases, and the four corners of the range onto which the light source device 1 can irradiate light (hereinbelow, also called the "imaging region") may be dark.

In the light source device 6, the first light source parts 10 are located at the four corners of the light-emitting region 50. The light emission amount of the first light source part 10 is greater than the light emission amount of the second light source part 20, and thus the amount of light incident on the lens 41 is increased, and the entire imaging region can be illuminated with reduced light unevenness. Otherwise, the configuration, operations, and effects according to the embodiment are similar to those of the first embodiment.

### First modification of sixth embodiment

FIG. 14A is a top view showing a light source device according to the modification.

In the light source device 6a according to the modification as shown in FIG. 14A, the first light source parts 10 are located at the four corners of the light-emitting region 50; and the area of the first light source part 10 is greater than the area of the second light source part 20 in a top view. As a result, more of the light emitted from the four first light source parts 10 located at the corners of the light-emitting region 50 can be incident on the lens 41. Otherwise, the configuration, operations, and effects according to the modification are similar to those of the sixth embodiment.

### Second modification of sixth embodiment

FIG. 14B is a top view showing a light source device according to the modification.

In the light source device 6b according to the modification as shown in FIG. 14B, the first light source parts 10 are located at the four corners of the light-emitting region 50; and the area of the second light source part 20 is greater than the area of the first light source part 10 in a top view. In the light source device 6b, four first light source parts 10 are located at the corners of the light-emitting region 50, and thus the light that is emitted from the four first light source parts 10 can be efficiently incident on the lens 41. Furthermore, the second light source part 20 that has a larger area than the first light source part 10 is located in the central region of the light-emitting region 50; and sufficient light also can be irradiated on the center and its vicinity of the imaging region. Otherwise, the configuration, operations, and effects according to the modification are similar to those of the sixth embodiment.

### Third modification of sixth embodiment

FIG. 15A is a top view showing a light source device according to the modification.

In the light source device 6c according to the modification as shown in FIG. 15A, a total of 357 light source parts are arranged in a matrix configuration of twenty-one rows and seventeen columns in the light-emitting region 50.

One first light source part 10 is located at each of the four corners of the light-emitting region 50; and 353 second light source parts 20 are located at the positions other than the four corners. Thus, for example, when the area of the light-emitting region 50 is substantially the same as the area of the light-emitting region 50 of the light source device 6b in a top view, the intensity distribution of the light emitted from the light source device 6c can be accurately controlled to match the angle of view of the camera and/or the distance between the light source device 6c and the imaging subject by increasing the quantity of light source parts such as in the light source device 6c. Otherwise, the configuration, operations, and effects according to the modification are similar to those of the sixth embodiment.

### Fourth modification of sixth embodiment

FIG. 15B is a top view showing a light source device according to the modification.

In the light source device 6d according to the modification as shown in FIG. 15B, the light source parts are arranged in a matrix configuration of twenty-one rows and seventeen columns in the light-emitting region 50. Nine first light source parts 10 are arranged in a matrix configuration of three rows and three columns at each of the four corners of the light-emitting region 50. In other words, a total of thirty-six first light source parts 10 are included. 321 second light source parts 20 are located at the other positions.

According to the modification, the nine first light source parts 10 that are located at the corner of the light-emitting region 50 form one group. Only one first power supply circuit 61 may be provided for the nine first light source parts 10 of the one group. In such a case, the light source device 6d includes four first power supply circuits 61. Similarly, one group may be formed of multiple second light source parts 20 to form multiple second light source part 20 groups; and the second power supply circuit 62 may be provided for each second light source part 20 group. As a result, the control is easier even when the quantity of light source parts is increased. Otherwise, the configuration, operations, and effects according to the modification are similar to those of the sixth embodiment.

### Seventh embodiment

FIG. 16 is a top view showing a light source device according to the embodiment.

In the light source device 7 according to the embodiment as shown in FIG. 16, the light source parts are arranged in a matrix configuration of seventeen rows and twenty-one columns in the light-emitting region 50. One or more of the first light source parts 10, one or more of the second light source parts 20, and one or more of third light source parts 30 are provided in the light-emitting region 50. For easier viewing of the drawing in FIG. 16, the first light source parts 10 are marked with dark hatching; the second light source parts 20 are marked with light hatching; and the third light source parts 30 are not marked with hatching.

Similarly to the first light source part 10d shown in FIG. 11, the first light source part 10 includes three first stacked bodies (i.e., the first stacked body 11, the first stacked body 12, and the first stacked body 13) stacked along the first direction Z. The three first stacked bodies are connected in series. Similarly to the second light source part 20d shown in FIG. 11, the second light source part 20 includes two second stacked bodies (i.e., the second stacked body 21 and the second stacked body 22) stacked along the first direction Z and connected in series. The third light source part 30 includes one third stacked body. Similarly to the second light source part 20 shown in FIG. 2, the third stacked body is a stacked body in which the p-type semiconductor layer, the active layer, and the n-type semiconductor layer are stacked along the first direction. Therefore, when the magnitude of the supplied current is equal between the light source parts, and the materials, thicknesses, areas, etc., of the semiconductor layers included in the light source parts are respectively similar, the ratio of the light emission amounts of the first, second, and third light source parts 10, 20, and 30 is substantially (3:2:1).

Nine first light source parts 10 are arranged in three rows and three columns in the central region of the light-emitting region 50; and one first light source part 10 is located at each of the four corners of the light-emitting region 50. Fifty-four second light source parts 20 are arranged to surround the nine first light source parts 10 located in the central region of the light-emitting region 50, such that two columns of the second light source parts 20 along the third direction Y are located at each of the two sides of the central region and three columns of the second light source parts 20 along the second direction X are located at each of the two sides of the central region. Sixty-eight second light source parts 20 are arranged so that one column of the second light source parts 20 extends along each of the four sides of the light-emitting region 50 except for the four corners. The third light source parts 30 are located at positions forming a frame shape of the light-emitting region 50 at which the first light source parts 10 and the second light source parts 20 are not located. Accordingly, the light-emitting region 50 includes thirteen first light source parts 10, 122 second light source parts 20, and 222 third light source parts 30.

The effects according to the embodiment are a combination of the effects according to the first embodiment and the effects according to the sixth embodiment. In other words, in wide-angle imaging, the light can be irradiated on a wide imaging region with reduced unevenness; and in telephoto imaging, a sufficient amount of light can be irradiated on a distant imaging subject. Specifically, not only are the first light source parts 10, which have large light emission amounts, located at the corners of the light-emitting region 50, but also the second light source parts 20, which have large light emission amounts second to those of the first light source parts 10, are located at the four sides of the light-emitting region 50; therefore, sufficient light can be irradiated not only from the four corners of the imaging region, but also from the outer perimeter portion of the imaging region. The irradiated light in telephoto imaging can be appropriately supplemented by the multiple second light source parts 20 surrounding the group of the first light source parts 10 located in the central region of the light-emitting region 50. Otherwise, the configuration, operations, and effects according to the embodiment are similar to those of the first embodiment.

### Eighth embodiment

FIG. 17 is a cross-sectional view showing a light source device according to the embodiment.

In the light source device 8 according to the embodiment as shown in FIG. 17, the first wavelength conversion member 16 is thicker than the second wavelength conversion member 26 in the first direction Z.

The first light source part 10 includes a substrate 10g. According to the embodiment, the substrate 10g is a substrate for growing the semiconductor layers from the n-type semiconductor layer 11n to the p-type semiconductor layer 12p and is, for example, a sapphire substrate. The substrate 10g contacts the n-type semiconductor layer 11n. The second light source part 20 includes a substrate 20g. According to the embodiment, the substrate 20g is a substrate for growing the semiconductor layers from the n-type semiconductor layer 21n to the p-type semiconductor layer 22p and is, for example, a sapphire substrate. The substrate 10g and the substrate 20g are thinned to any thickness after the semiconductor layers are grown. According to the embodiment, the substrate 10g is thinner than the substrate 20g. The substrate 10g and the substrate 20g are not limited to growth substrates, and may be support substrates supporting the semiconductor layers.

The type and concentration of the wavelength conversion substance of the first wavelength conversion member 16 may be the same as the type and concentration of the wavelength conversion substance of the second wavelength conversion member 26. In such a case, the amount of the wavelength conversion substance included in the first wavelength conversion member 16 is greater than the amount of the wavelength conversion substance included in the second wavelength conversion member 26.

The upper surface of the first wavelength conversion member 16 is at substantially the same position as the upper surface of the second wavelength conversion member 26 in the first direction Z. The thickness of the first light-transmitting member 17 is substantially equal to the thickness of the second light-transmitting member 27. Accordingly, the upper surface of the first light-transmitting member 17 is at substantially the same position as the upper surface of the second light-transmitting member 27 in the first direction Z.

The substrate 10g and the first wavelength conversion member 16 are bonded via a first bonding member 18. The second light source part 20 and the second wavelength conversion member 26 are bonded via a second bonding member 28. The first bonding member 18 and the second bonding member 28 are, for example, adhesives formed of a light-transmitting resin. The first bonding member 18 and the second bonding member 28 may not be included.

According to the modification, suitable amounts of the wavelength conversion member can be provided on the first light source part 10 and on the second light source part 20 by setting the first wavelength conversion member 16 to be thicker than the second wavelength conversion member 26. As a result, the uniformity of the emitted light is increased.

Also, the light-emitting surface of the light source device 8 is flat because the upper surface of the first light-transmitting member 17 is at substantially the same position as the upper surface of the second light-transmitting member 27 in the first direction Z. As a result, the handling is good in the mounting process of the light source device 8.

Furthermore, according to the embodiment, the substrate 10g is thinner than the substrate 20g. As a result, the scattering and absorption of the light by the substrate 10g can be reduced when it is necessary for the first light source part 10 to have more intense light. Otherwise, the configuration, operations, and effects according to the embodiment are similar to those of the first embodiment.

### First modification of eighth embodiment

FIG. 18 is a cross-sectional view showing a light source device according to the modification.

The configuration of the first wavelength conversion member of the light source device 8a according to the modification is different from that of the light source device 8 according to the eighth embodiment.

As shown in FIG. 18, the light source device 8a includes a first wavelength conversion member 16a. The first wavelength conversion member 16a includes a wavelength conversion layer 16b and a wavelength conversion layer 16c. The wavelength conversion layer 16c is located between the substrate 10g and the wavelength conversion layer 16b. The configuration of the wavelength conversion layer 16b, i.e., the thickness, type, and concentration of the wavelength conversion substance of the wavelength conversion layer 16b, may be the same as the configuration of the second wavelength conversion member 26. At this time, the concentration of the wavelength conversion substance of the wavelength conversion layer 16c is greater than the concentration of the wavelength conversion substance of the wavelength conversion layer 16b. Accordingly, the amount of the wavelength conversion substance included in the first wavelength conversion member 16a is greater than the amount of the wavelength conversion substance included in the second wavelength conversion member 26.

According to the modification, by the first wavelength conversion member 16a including the wavelength conversion layer 16c that has a higher wavelength conversion substance concentration, the light emission color difference between the light source parts due to the light emission amount difference between the light source parts can be adjusted.

Because the concentration of the wavelength conversion substance of the wavelength conversion layer 16c is greater than the concentration of the wavelength conversion substance of the wavelength conversion layer 16b, the heat generation amount of the wavelength conversion layer 16c is greater than the heat generation amount of the wavelength conversion layer 16b when the light from the first light source part 10 is incident on the first wavelength conversion member 16a. However, the wavelength conversion layer 16c is located more proximate to the substrate 10g, the semiconductor layers, and the wiring substrate 80 than the wavelength conversion layer 16b, and thus the heat dissipation via the substrate 10g, the semiconductor layers, and the wiring substrate 80 is high. As a result, the concentration of heat inside the light source device 8a can be relaxed. Otherwise, the configuration, operations, and effects according to the modification are similar to those of the eighth embodiment.

### Second modification of eighth embodiment

FIG. 19 is a cross-sectional view showing a light source device according to the modification.

The light source device 8b according to the modification as shown in FIG. 19 differs from the light source device 8 according to the eighth embodiment in that the thickness of the substrate 10g is substantially equal to the thickness of the substrate 20g, and the first wavelength conversion member 16 protrudes in the first direction Z relative to the second wavelength conversion member 26.

According to the modification, the light L2 that is emitted from the second light source part 20 at a low angle can be incident on the lens 41 by being reflected by the lateral surface of the light-shielding member 70 located at the periphery of the first wavelength conversion member 16. As a result, the utilization efficiency of the light can be increased. The light L2 shown in FIG. 19 is light that would become stray light if the first wavelength conversion member 16 did not protrude. Otherwise, the configuration, operations, and effects according to the modification are similar to those of the eighth embodiment.

### Ninth embodiment

FIG. 20A is a cross-sectional view showing a light source device according to the embodiment.

As shown in FIG. 20A, the configuration of the lens member 40 and the peripheral portions of the lens member 40 of the light source device 9 according to the embodiment are different from those of the first embodiment.

The light source device 9 as shown in FIG. 20A includes a support member 45. The support member 45 fixes the lens member 40 to the wiring substrate 80. The support member 45 has a frame shape or a ring shape extending in the first direction Z. The support member 45 surrounds the light-emitting region 50 in a top view. The lower surface of the support member 45 is bonded to the upper surface of the wiring substrate 80. The support part 42 of the lens member 40 is bonded to the inner surface of the support member 45.

The support member 45 is formed of a light-shielding material. The light-shielding material is, for example, a white or black resin material. The resin material includes a filler in a resin base material. The resin base material includes, for example, a polycarbonate resin, an acrylic resin, a silicone resin, or an epoxy resin. When the resin material is white, for example, a substance such as titanium oxide, silica, alumina, or the like that scatters light is used as a filler. When the resin material is black, for example, a substance such as carbon, a coating, or the like that absorbs light is used as the filler.

According to the embodiment, the stray light can be reduced by including the light-shielding support member 45. Otherwise, the configuration, operations, and effects according to the embodiment are similar to those of the first embodiment.

### First modification of ninth embodiment

FIG. 20B is a cross-sectional view showing a light source device according to the modification.

As shown in FIG. 20B, the shape of the lens member of the light source device 9a according to the modification is different from that of the first embodiment.

In the light source device 9a as shown in FIG. 20B, a Fresnel lens is provided as a lens member 44. As a result, the light source device 9a can be thinned. In other words, the length of the light source device 9a in the first direction Z can be reduced. Otherwise, the configuration, operations, and effects according to the modification are similar to those of the first embodiment.

### Second modification of ninth embodiment

FIG. 20C is a cross-sectional view showing a light source device according to the modification.

As shown in FIG. 20C, the modification is a combination of the ninth embodiment and the first modification of the ninth embodiment. In other words, the light source device 9b according to the modification includes the support member 45 and the Fresnel lens-shaped lens member 44; and the support member 45 fixes the lens member 44 to the wiring substrate 80. Otherwise, the configuration, operations, and effects according to the modification are similar to those of the ninth embodiment and the first modification of the ninth embodiment.

### Third modification of ninth embodiment

FIG. 20D is a cross-sectional view showing a light source device according to the modification.

In the light source device 9c according to the modification as shown in FIG. 20D, the support member 45 holds three lenses 46a, 46b, and 46c. The three lenses 46a, 46b, and 46c may be bonded to each other by, for example, a bonding member 47 such as a resin, double-sided tape, etc. The lenses 46a, 46b, and 46c are, for example, aspherical lenses. As a result, the irradiation of the light by the light source device 9c can be controlled with higher accuracy. The lenses are not limited to three, and may be two or more. Otherwise, the configuration, operations, and effects according to the modification are similar to those of the ninth embodiment.

### Tenth embodiment

FIG. 21 is a cross-sectional view showing a light source device according to the embodiment.

As shown in FIG. 21, the light source device 9e according to the embodiment differs from the first embodiment in that the lens member 40 is separated from the wiring substrate 80.

As shown in FIG. 21, the light source device 9e is located inside a housing 91 of a mobile terminal 90 such as a smartphone, etc. The lens member 40 is located in the housing 91 of the mobile terminal 90. In other words, the light source device 9e does not include the lens member 40. Specifically, the support part 42 of the lens member 40 is bonded to the inner surface of the housing 91 of the mobile terminal 90 by, for example, the bonding member 47 such as a resin, double-sided tape, etc. Also, the housing 91 has an opening; and a cover member 92 is located in the opening of the housing 91 to face the lens 41 of the lens member 40. The cover member 92 is, for example, a light-transmitting member formed of glass or a resin material.

As a result, the light that is emitted from the light source device 9e is condensed by the lens 41 of the lens member 40 located in the housing 91, is transmitted by the cover member 92, and exits outside the mobile terminal 90. According to the embodiment, a thinner and less costly light source device 9e can be achieved by utilizing the lens member 40 located in the housing 91. Otherwise, the configuration, operations, and effects according to the embodiment are similar to those of the first embodiment.

### Eleventh embodiment

The embodiment is an example of a method for manufacturing a light source device.

FIGS. 22A to 22E are cross-sectional views showing the method for manufacturing the light source device according to the embodiment.

Although an example of manufacturing the light source device 1 according to the first embodiment is described in the embodiment, this is also similar for methods for manufacturing the light source devices according to the other embodiments. Also, the method for manufacturing the light source device 1 that includes the first light source part 10 including the first wavelength conversion member 16 and the second light source part 20 including the second wavelength conversion member 26 are described as an example according to the embodiment; the members included in the first light source part 10 may be referred to as a first unit 19; and the members included in the second light source part 20 may be referred to as a second unit 29. The light-transmitting members are not illustrated.

First, a first wavelength conversion sheet and a second wavelength conversion sheet that include wavelength conversion substances inside resin materials are prepared. At this time, the amount of the wavelength conversion substance included in the first wavelength conversion sheet is set to be greater than the amount of the wavelength conversion substance included in the second wavelength conversion sheet.

Then, as shown in FIG. 22A, the second wavelength conversion sheet is placed on a mounting substrate 201; and the multiple second wavelength conversion members 26 are made by cutting the second wavelength conversion sheet in this state by using, for example, a cutting blade or a laser. When the second light-transmitting member 27 is included, the second light-transmitting member 27 is bonded to the second wavelength conversion member 26 at this stage. Then, the multiple second wavelength conversion members 26 are arranged in a matrix configuration on the mounting substrate 201. When the second light-transmitting member 27 is included, the multiple second wavelength conversion members 26 and the multiple second light-transmitting members 27 may be simultaneously made by bonding a second light-transmitting sheet to the second wavelength conversion sheet and by cutting the second wavelength conversion sheet and the second light-transmitting sheet.

Continuing as shown in FIG. 22B, some of the second wavelength conversion members 26 at desired positions inside the light-emitting region 50 are replaced with the first wavelength conversion members 16. In other words, some of the second wavelength conversion members 26 on the mounting substrate 201 are selected to be replaced with the first wavelength conversion members 16 and are removed; and the first wavelength conversion members 16 are provided at the removed positions.

Then, as shown in FIG. 22C, the first unit 19 that includes the first stacked body 11, the first stacked body 12, the p-side electrode 15p, and the n-side electrode 15n is provided on the first wavelength conversion member 16. Also, the second unit 29 that includes the second stacked body 21, the p-side electrode 25p, and the n-side electrode 25n is provided on the second wavelength conversion member 26. In other words, two types of units are provided according to the types of wavelength conversion members. For example, the first unit 19 and the second unit 29 may be bonded respectively to the first and second wavelength conversion members 16 and 26 by using a bonding member such as a resin, etc.

Continuing as shown in FIG. 22D, the light-shielding member 70 may be provided on the mounting substrate 201. The light-shielding member 70 covers the structure body formed of the first wavelength conversion member 16 and the first unit 19 as one piece, and the structure body formed of the second wavelength conversion member 26 and the second unit 29 as one piece. Then, the p-side electrode 15p, the n-side electrode 15n, the p-side electrode 25p, and the n-side electrode 25n are exposed from the light-shielding member 70 by polishing the upper surface of the light-shielding member 70.

Then, as shown in FIG. 22E, the light-emitting part 71 is made to include one or more first light source parts 10 and one or more second light source parts 20 by cutting the light-shielding member 70. The singulated light-emitting part 71 includes multiple light source parts and is used in one light source device 1. Thus, the light source device 1 is manufactured.

The light-emitting part 71 (in other words, the light source device 1) that is made may be mounted so that the p-side electrode 15p, the n-side electrode 15n, the p-side electrode 25p, and the n-side electrode 25n of each first light source part 10 and each second light source part 20 included in the light-emitting part 71 are connected to predetermined wiring parts of the wiring substrate 80. Then, the lens member 40 is mounted to the wiring substrate 80 so that the lens 41 and the light-emitting part 71 face each other. As a result, the air layer 72 is formed between the light-emitting part 71 and the lens member 40. Also, the first power supply circuit 61 and the second power supply circuit 62 are connected to the wiring substrate 80. Thus, the light source device 1 that includes the wiring substrate 80, the light-shielding member 70, the lens member 40, the first power supply circuit 61, and the second power supply circuit 62 such as those shown in FIGS. 1 to 3 is manufactured.

To adjust the contents of the wavelength conversion substances included in the first and second wavelength conversion members 16 and 26, some of the second wavelength conversion members 26 shown in FIG. 22B are replaced with the first wavelength conversion members 16 in the processes described above, but the amounts of the wavelength conversion substances may be set to be different from each other by another technique. For example, instead of the processes described above, both the first unit 19 and the second unit 29 may include the second wavelength conversion member 26; and the amount of the wavelength conversion substance may be increased by, for example, applying a resin including the wavelength conversion substance on the second wavelength conversion members 26 located at the first units 19. This is substantially equivalent to providing the first wavelength conversion members 16, that include more wavelength conversion substance than the second wavelength conversion members 26, at the first units 19.

Embodiments and their modifications described above are examples embodying technology of the disclosure; and the technology of the disclosure is not limited to these embodiments and their modifications. For example, additions, deletions, or modifications of some of the components or processes in the embodiments and modifications described above are also included in the technology of the disclosure. Also, the embodiments and modifications described above can be performed in combination with each other.

The light source device of the disclosure can be preferably utilized for a flash of a camera, lighting, an automotive headlight, etc. However, the light source device of the disclosure is not limited to such applications.

The disclosure includes the following aspects.

### Note 1

A light source device, comprising:
one or more first light source parts;
one or more second light source parts; and
a light-shielding member located between the first light source part and the second light source part, wherein
the first light source part includes two or more first stacked bodies, each of the two or more first stacked bodies including a p-type semiconductor layer, an active layer, and an n-type semiconductor layer stacked along a first direction,
the second light source part includes one or more second stacked bodies, each of the one or more second stacked bodies including a p-type semiconductor layer, an active layer, and an n-type semiconductor layer stacked along the first direction,
the two or more first stacked bodies of the first light source part are stacked continuously along the first direction,
a quantity of the two or more first stacked bodies included in the first light source part is greater than a quantity of the one or more second stacked bodies included in the second light source part.

### Note 2

The light source device according to Note 1, wherein
the first light source part includes two of the first stacked bodies, and
the second light source part includes one of the second stacked bodies.

### Note 3

The light source device according to Note 1, wherein
the first light source part includes three of the first stacked bodies,
the second light source part includes two of the second stacked bodies, and
the two second stacked bodies of the second light source part are stacked continuously along the first direction.

### Note 4

The light source device according to any one of Notes 1 to 3, wherein
two or more of the second light source parts are included, and
the two or more of the second light source parts are located with the first light source part interposed between the two or more of the second light source parts in a top view.

### Note 5

The light source device according to any one of Notes 1 to 4, wherein
the one or more first light source parts and the one or more second light source parts are arranged in a matrix configuration and form a light-emitting region in a top view.

### Note 6

The light source device according to Note 5, wherein
at least one of the first light source parts is located in a central region of the light-emitting region in a top view.

### Note 7

The light source device according to Note 5 or 6, wherein
at least one of the first light source parts is located at each of four corners of the light-emitting region in a top view.

### Note 8

The light source device according to any one of Notes 1 to 7, wherein
a size of the first light source part is different from a size of the second light source part in a top view.

### Note 9

The light source device according to any one of Notes 1 to 8, wherein
the first light source part further includes a first wavelength conversion member located on the first stacked body,
the second light source part further includes a second wavelength conversion member located on the second stacked body, and
a content of a wavelength conversion substance included in the first wavelength conversion member is greater than a content of a wavelength conversion substance included in the second wavelength conversion member.

### Note 10

The light source device according to any one of Notes 1 to 9, comprising:
a first power supply circuit supplying a first voltage to the first light source part; and
a second power supply circuit supplying a second voltage to the second light source part, wherein
a value of a ratio of the first voltage to the second voltage is not less than a value of a ratio of a quantity of stacks of the first stacked body of the first light source part to a quantity of stacks of the second stacked body of the second light source part.

### Note 11

The light source device according to any one of Notes 1 to 10, wherein
the two or more first stacked bodies of the first light source part are connected.

### Note 12

The light source device according to any one of Notes 1 to 10, wherein
the two or more first stacked bodies of the first light source part are connected in parallel.

### Note 13

The light source device according to any one of Notes 1 to 12, wherein
the light source device is for a flash.

### Note 14

The light source device according to any one of Notes 1 to 13, further comprising:
a lens on which light emitted from the first light source part and light emitted from the second light source part are incident.

### Note 15

A light source device, comprising:
one or more first light source parts;
one or more second light source parts; and
a light-shielding member located between the first light source part and the second light source part,
the first light source part including two or more first stacked bodies, each of the two or more first stacked bodies including a first-conductivity-type semiconductor layer, an active layer, and a second-conductivity-type semiconductor layer stacked in the first stacked body,
the second light source part including one or more second stacked bodies, each of the one or more second stacked bodies including a first-conductivity-type semiconductor layer, an active layer, and a second-conductivity-type semiconductor layer stacked in the second stacked body, wherein
the two or more first stacked bodies of the first light source part are stacked continuously along a stacking direction of the first stacked body,
a quantity of the two or more first stacked bodies included in the first light source part is greater than a quantity of the one or more second stacked bodies included in the second light source part.

### [Reference Numeral List]

1, 1a, 1b, 1c, 1d, 2, 3, 4, 4a, 5, 6, 6a, 6b, 6c, 6d, 7, 8, 8a, 8b, 9, 9a, 9b, 9c, 9e light source device
10, 10a, 10b, 10c, 10d first light source part
10g substrate
10n n-type semiconductor layer
10p p-type semiconductor layer
11 first stacked body
11a active layer
11n n-type semiconductor layer
11p p-type semiconductor layer
12 first stacked body
12a active layer
12n n-type semiconductor layer
12p p-type semiconductor layer
13 first stacked body
13a active layer
13n n-type semiconductor layer
13p p-type semiconductor layer
14 tunnel junction layer
15m common electrode
15n, 15n1, 15n2 n-side electrode
15p, 15p1, 15p2 p-side electrode
16, 16a first wavelength conversion member
16b, 16c, 16d wavelength conversion layer
17 first light-transmitting member
18, 18a first bonding member
19 first unit
20, 20d second light source part
20g substrate
21 second stacked body
21a active layer
21n n-type semiconductor layer
21p p-type semiconductor layer
22 second stacked body
22a active layer
22n n-type semiconductor layer
22p p-type semiconductor layer
25n n-side electrode
25p p-side electrode
26 second wavelength conversion member
27 second light-transmitting member
28 second bonding member
29 second unit
30 third light source part
40 lens member
41 lens
41c central axis
42 support part
44 lens member
45 support member
46a, 46b, 46c lens
47 bonding member
50 light-emitting region
61, 61a first power supply circuit
62 second power supply circuit
70 light-shielding member
71, 71c light-emitting part
72 air layer
80 wiring substrate
81 ASIC substrate
90 mobile terminal
91 housing
92 cover member
101, 102 imaging subject
201 mounting substrate
L1, L2, Lc, Le light
I1 first current
I2 second current
V1 first voltage
V2 second voltage

## Claims

1. A light source device, comprising:
one or more first light source parts;
one or more second light source parts; and
a light-shielding member located between the first light source part and the second light source part, wherein
the first light source part includes two or more first stacked bodies, each of the two or more first stacked bodies including a p-type semiconductor layer, an active layer, and an n-type semiconductor layer stacked along a first direction,
the second light source part includes one or more second stacked bodies, each of the one or more second stacked bodies including a p-type semiconductor layer, an active layer, and an n-type semiconductor layer stacked along the first direction,
the two or more first stacked bodies of the first light source part are stacked continuously along the first direction,
a quantity of the two or more first stacked bodies included in the first light source part is greater than a quantity of the one or more second stacked bodies included in the second light source part.

2. The light source device according to claim 1, wherein
the first light source part includes two of the first stacked bodies, and
the second light source part includes one of the second stacked bodies.

3. The light source device according to claim 1, wherein
the first light source part includes three of the first stacked bodies,
the second light source part includes two of the second stacked bodies, and
the two second stacked bodies of the second light source part are stacked continuously along the first direction.

4. The light source device according to any one of claims 1 to 3, wherein
two or more of the second light source parts are included, and
the two or more of the second light source parts are located with the first light source part interposed between the two or more of the second light source parts in a top view.

5. The light source device according to any one of claims 1 to 4, wherein
the one or more first light source parts and the one or more second light source parts are arranged in a matrix configuration and form a light-emitting region in a top view.

6. The light source device according to claim 5, wherein
at least one of the first light source parts is located in a central region of the light-emitting region in a top view.

7. The light source device according to claim 5 or 6, wherein
at least one of the first light source parts is located at each of four corners of the light-emitting region in a top view.

8. The light source device according to any one of claims 1 to 7, wherein
a size of the first light source part is different from a size of the second light source part in a top view.

9. The light source device according to any one of claims 1 to 8, wherein
the first light source part further includes a first wavelength conversion member located on the first stacked body,
the second light source part further includes a second wavelength conversion member located on the second stacked body, and
a content of a wavelength conversion substance included in the first wavelength conversion member is greater than a content of a wavelength conversion substance included in the second wavelength conversion member.

10. The light source device according to any one of claims 1 to 9, comprising:
a first power supply circuit supplying a first voltage to the first light source part; and
a second power supply circuit supplying a second voltage to the second light source part, wherein
a value of a ratio of the first voltage to the second voltage is not less than a value of a ratio of a quantity of stacks of the first stacked body of the first light source part to a quantity of stacks of the second stacked body of the second light source part.

11. The light source device according to any one of claims 1 to 10, wherein
the two or more first stacked bodies of the first light source part are connected in series.

12. The light source device according to any one of claims 1 to 10, wherein
the two or more first stacked bodies of the first light source part are connected in parallel.

13. The light source device according to any one of claims 1 to 12, wherein
the light source device is for a flash.

14. The light source device according to any one of claims 1 to 13, further comprising:
a lens on which light emitted from the first light source part and light emitted from the second light source part are incident.

15. A light source device, comprising:
one or more first light source parts;
one or more second light source parts; and
a light-shielding member located between the first light source part and the second light source part,
the first light source part including two or more first stacked bodies, each of the two or more first stacked bodies including a first-conductivity-type semiconductor layer, an active layer, and a second-conductivity-type semiconductor layer stacked in the first stacked body,
the second light source part including one or more second stacked bodies, each of the one or more second stacked bodies including a first-conductivity-type semiconductor layer, an active layer, and a second-conductivity-type semiconductor layer stacked in the second stacked body, wherein
the two or more first stacked bodies of the first light source part are stacked continuously along a stacking direction of the first stacked body,
a quantity of the two or more first stacked bodies included in the first light source part is greater than a quantity of the one or more second stacked bodies included in the second light source part.
